(19) Europäisches Patentamt
European Patent Office
Office européen des brevets

(11) **EP 4 200 670 B1**

(12) **EUROPEAN PATENT SPECIFICATION**

(45) Date of publication and mention
of the grant of the patent:
**15.04.2026  Bulletin 2026/16**

(21) Application number: **21749855.9**

(22) Date of filing: **29.07.2021**

(51) International Patent Classification (IPC):
**G03F 7/20** *(2006.01)*          **G03F 1/62** *(2012.01)*
**G03F 1/64** *(2012.01)*

(52) Cooperative Patent Classification (CPC):
**G03F 1/62; G03F 1/64; G03F 7/707; G03F 7/70916**

(86) International application number:
**PCT/EP2021/071266**

(87) International publication number:
**WO 2022/042993 (03.03.2022 Gazette 2022/09)**

(54) **APPARATUS FOR PROCESSING A RETICLE AND PELLICLE ASSEMBLY**

VORRICHTUNG ZUR VERARBEITUNG EINER RETIKEL- UND PELLIKELANORDNUNG

APPAREIL DE TRAITEMENT D'UN ENSEMBLE RÉTICULE ET PELLICULE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **24.08.2020  EP 20192426**
              **29.09.2020  EP 20199008**

(43) Date of publication of application:
**28.06.2023  Bulletin 2023/26**

(73) Proprietor: **ASML Netherlands B.V.**
**5500 AH Veldhoven (NL)**

(72) Inventors:
• **BANINE, Vadim, Yevgenyevich**
  **5500 AH Veldhoven (NL)**
• **VERMEULEN, Paul, Alexander**
  **5500 AH Veldhoven (NL)**
• **DE MEIJERE, Cornelis, Adrianus**
  **5500 AH Veldhoven (NL)**
• **MOORS, Johannes, Hubertus, Josephina**
  **5500 AH Veldhoven (NL)**
• **NIKIPELOV, Andrey**
  **5500 AH Veldhoven (NL)**
• **SALMASO, Guido**
  **5500 AH Veldhoven (NL)**
• **VAN DE KERKHOF, Marcus, Adrianus**
  **5500 AH Veldhoven (NL)**
• **YAGHOOBI, Parham**
  **5500 AH Veldhoven (NL)**

(74) Representative: **ASML Netherlands B.V.**
**Corporate Intellectual Property**
**P.O. Box 324**
**5500 AH Veldhoven (NL)**

(56) References cited:
**WO-A1-2020/064217        WO-A2-2016/079051**
**US-A1- 2015 131 071        US-A1- 2015 160 569**
**US-A1- 2016 225 582        US-A1- 2016 291 460**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**EP 4 200 670 B1**

**Description**

<u>CROSS-REFERENCE TO RELATED APPLICATIONS</u>

This application claims priority of EP application 20192426.3 which was filed on August 24, 2020 and EP application 20199008.2 which was filed on September 29, 2020.

<u>FIELD</u>

The present invention relates to an apparatus and associated method for processing a reticle and pellicle assembly for use within an extreme ultraviolet (EUV) lithographic apparatus. The present invention also relates to a reticle and pellicle assembly that may be particularly suitable for use in the apparatus and method for processing a reticle and pellicle assembly.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g., a mask) onto a layer of radiation-sensitive material (resist) provided on a substrate.

The wavelength of radiation used by a lithographic apparatus to project a pattern onto a substrate determines the minimum size of features that can be formed on that substrate. A lithographic apparatus that uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

A patterning device (e.g., a mask) that is used to impart a pattern to a radiation beam in a lithographic apparatus may form part of a mask assembly. A mask assembly may include a pellicle that protects the patterning device from particle contamination. The pellicle may be supported by a pellicle frame.

It may be desirable to provide an apparatus that obviates or mitigates one or more problems associated with the prior art.

WO2020/064217 discloses a system for securing a particle to a pellicle membrane for subsequent use in a lithographic apparatus, the system comprising a particle securement device configured to secure the particle to the pellicle membrane. The particle securement device is configured to direct an electron beam or radiation beam such that the electron beam or the radiation beam passes through the pellicle membrane before being incident on the particle.

US2015/0160569 A1 discloses a reflector that includes a reflecting surface or structure provided with a cap layer formed from Silicene or a Silicene derivative. The reflector may be provided in a lithographic apparatus.

US2015/0131071 A1 discloses a semiconductor device manufacturing apparatus including a mask stage including a mask holder system that fixes a photomask, the mask holder system having a first fixing portion mounted at a first position of the mask holder system to fix the photomask, and a second fixing portion at a second position of the mask holder system and spaced apart from the first position, the second fixing portion fixing a pellicle assembly to be spaced apart from the photomask on the first fixing portion.

US2016/0225582 A1 discloses a system for imaging a sample through a protective pellicle. The system includes an electron beam source configured to generate an electron beam and a sample stage configured to secure a sample and a pellicle, wherein the pellicle is disposed above the sample. The system also includes an electron-optical column including a set of electron-optical elements to direct at least a portion of the electron beam through the pellicle and onto a portion of the sample. In addition, the system includes a detector assembly positioned above the pellicle and configured to detect electrons emanating from the surface of the sample.

WO2016/079051 discloses a mask assembly suitable for use in a lithographic process, the mask assembly comprising a patterning device; and a pellicle frame configured to support a pellicle and mounted on the patterning device with a mount; wherein the mount is configured to suspend the pellicle frame relative to the patterning device such that there is a gap between the pellicle frame and the patterning device; and wherein the mount provides a releasably engageable attachment between the patterning device and the pellicle frame.

US2016/0291460 A1 discloses a pellicle wherein the pellicle frame is formed with a protrusion which extends either inward or outward from the pellicle frame so that an air passage (vent hole) can extend in it to turn upward or downward to open in the atmosphere or in the pellicle closed space (the space interior to the pellicle frame) so that it is possible to secure a wider opening area for filtration to enable prompt air ventilation whereby the pellicle membrane does not undergo extreme inflation or deflation and thus the pellicle membrane is protected from damages.

SUMMARY

According to a first aspect of the invention as defined by the appended independent claim 1, there is provided an apparatus comprising: a support for supporting a reticle and pellicle assembly; a hydrogen supply operable to supply hydrogen in the vicinity of a pellicle of the reticle and pellicle assembly when supported by the support; and an electron source operable to direct electrons so as to be incident on a pellicle of a reticle and pellicle assembly when supported by the support; wherein a part of the support which, in use, contacts the reticle and pellicle assembly comprises an electron sink.

The apparatus according to the first aspect of the invention is advantageous as now discussed.

When a reticle is exposed to air, it will become partially oxidized. This partial oxidization affects the reflectivity of the reticle, which is undesirable. In particular, the effect on the reflectivity will, in general, vary across the reticle. Within an EUV lithographic apparatus, hydrogen may be provided in the vicinity of the reticle stage. For pellicle-free reticles, in the presence of the EUV radiation, this hydrogen gas will form a plasma which will reduce the partially oxidized surface, returning the reflectivity to nominal and consistent levels. Typically, reflectivity of pellicle-free reticles drifts for a few dies when reticles previously exposed to air are first exposed to EUV and then reaches a steady state. The productivity loss of such a reflectivity drift is tolerable.

However, for pelliclized reticles the flux of active species from the hydrogen plasma is significantly reduced. This is because the pellicle film forms a barrier for species generated in EUV beam next to pellicle front side. Further, active species generated in the volume between the reticle and pellicle will be partially quenched (recombined, associated) at the surfaces of reticle and pellicle and this effect further reduces the flux of active species available for oxygen abstraction.

In addition, water and/or oxygen released from the reticle front side and pellicle back side cannot easily exit the volume between the pellicle and the reticle (typically only a very narrow slit is provided between the pellicle frame and reticle front side). Furthermore, any oxygen and water trapped between pellicle film and reticle front side can be re-captured (re-oxidizing the reticle and pellicle or getting adsorbed), extending the time of transmission recovery. Since there are surface oxides on both the pellicle (front side and back side) and the reticle (front side) the transmission of the whole system varies by a factor of 2-3 more than a pellicle-free system. The time taken for a pelliclized reticle to reach a steady state is of the order of 10-100 times greater than for a pellicle-free reticle. As a result, the transmission may drift for of the order of 2-20 wafers before reaching the steady-state. This is a significant loss of productivity.

The electron source of the apparatus according to the first aspect is operable to direct electrons so as to be incident on a pellicle of a reticle and pellicle assembly when supported by the support. At least a portion of such incident electrons will propagate through the pellicle to the reticle. The electrons can interact with the hydrogen from the hydrogen source to create active species, such as $H^*$, $H^+$, $H_2^+$, $H_3^+$, which can reduce (partially) oxidized surfaces, such as reticle front side, and/or promote adsorbed oxygen desorption.

The hydrogen supply may be operable to direct hydrogen between the reticle and the pellicle of the reticle and pellicle assembly when supported by the support.

That is, the hydrogen supply may be operable to provide a flow of hydrogen between the pellicle and the reticle. Such a flow may be substantially in one direction and may, for example, be referred to as a cross-flow. Advantageously, this can refresh gas in the volume between the reticle and the pellicle and therefore accelerate water removal and reduce residence time for water molecules (generated during reduction by active species) on and between critical surfaces. Pellicles can typically withstand up to 100 Pa overpressure, thus a significant flow can be provided with a pressure difference across the pellicle around 10-50 Pa (allowing a factor of 2 margin for safety). In some embodiments, hydrogen may even be provided between the reticle and the pellicle at pressures of the order of 10-100 Pa.

The hydrogen supply may be operable to supply hydrogen at a pressure in the range 50 to 100 Pa.

In particular, the hydrogen supply may be operable to direct hydrogen between the reticle and the pellicle of the reticle and pellicle assembly when supported by the support at a pressure in the range 50 to 100 Pa.

With such an arrangements, the hydrogen pressure between the pellicle and reticle (and, optionally above a front surface of the pellicle) may be boosted from a typical value of 5-10 Pa within an EUV lithographic apparatus. Advantageously, this can increase generation of active species under the irradiation from the electron source and/or DUV or VUV radiation that may be emitted as Bremsstrahlung radiation.

The apparatus may further comprise a thermal conditioning unit operable to control a temperature of a reticle and pellicle assembly supported by the support.

The thermal conditioning unit may comprise a heater operable to increase a temperature of a reticle and pellicle assembly supported by the support.

Some heat will be provided to the reticle and pellicle assembly by the electron source. The additional heat provided by such a heater may promote water outgassing to reduce residence time of water on relevant surfaces. It is expected that the residence time may be reduced by a factor of 2-10 for every 10 °C increase in temperature of the reticle and pellicle assembly.

The heater may, for example, comprise a radiation source operable to irradiate the pellicle and/or reticle.

The thermal conditioning unit may comprise a cooling system operable to reduce a temperature of a reticle and pellicle assembly supported by the support.

It will be appreciated that in the absence of any such cooling, the process of cleaning a reticle and pellicle assembly using the apparatus of the first aspect of the invention may increase the temperature of the reticle and pellicle assembly. For example, in use, the electron source may provide a heat load to the assembly of the order of 10-100 W. However, it may be important for the reticle and pellicle assembly to be at substantially the same temperature as a reticle stage before it can be clamped the reticle stage and used as part of a lithographic process. The provision of a cooling system may reduce the amount of time taken following the cleaning process before the reticle and pellicle assembly can be safely clamped onto a reticle stage.

The support may be configured to contact a pellicle of the reticle and pellicle assembly in use.

A part of the support which, in use, contacts the reticle and pellicle assembly may comprise an electron sink.

For example, the part of the support which, in use, contacts the reticle and pellicle assembly may be grounded. The part of the support which, in use, contacts the reticle and pellicle assembly may comprise part of the pellicle and/or part of the reticle. Such an electron sink may prevent the pellicle from accumulating sufficient charge so as to rupture due to electrostatic pressure or spark damage occurring to the reticle and/or pellicle.

In some embodiments, a conducting coating is provided on at least on the part of the pellicle. For example, a conducting coating may be provided on a border of the pellicle, optionally extending to the membrane of the pellicle but not obstructing EUV irradiation of a quality area of the reticle. The conducting coating may be provided on a front side of the pellicle border.

When a reticle and membrane assembly is supported by the support, the support may provide an electrical connection between the reticle front surface and the pellicle membrane.

Advantageously, this can reduce any biasing voltage across the reticle and pellicle (which could exert electrostatic pressure on the pellicle).

The electron source may be arranged to direct electrons so as to be incident on a pellicle of a reticle and pellicle assembly when supported by the support such that a portion of said electrons which propagates through the pellicle has an energy of less than 500 eV.

In some embodiments, the electron source may be arranged such that the portion of electrons which propagates through the pellicle has an energy of less than 100 eV. This may ensure that the pellicle does not rupture due to electrostatic attraction to the reticle (pellicles are known to break, if there is a voltage drop to reticle of the order of 200 V).

The apparatus may further comprise an electromagnetic radiation source operable to direct electromagnetic radiation at the pellicle.

For example, such an electromagnetic radiation source may comprise a laser, for example an ultraviolet (UV) or deep ultraviolet (DUV) laser. Such an electromagnetic radiation source is operable to provide a photo-current to the pellicle to compensate for the charging by the electron source (for example by releasing electrons via the photoelectric effect).

The electron source may be arranged to direct electrons so as to be incident on a pellicle of a reticle and pellicle assembly when supported by the support such that a portion of said electrons which propagates through the pellicle achieves a secondary electron yield of greater than 1.

This may be achieved is a beam of electrons from the electron source, once attenuated by the pellicle has an energy of approximately 100-300 eV. Advantageously, with such an arrangement any biasing voltage across the reticle and the pellicle may be minimized whilst only the pellicle is grounded.

The apparatus may further comprise an enclosure. The support may be disposed in the enclosure and the hydrogen supply may be operable to supply hydrogen to the enclosure.

The enclosure may be provided with one or more pumps. The hydrogen supply and said pumps may be used to control a pressure within the enclosure. The hydrogen supply and said pumps may be considered to form part of a pressure control system.

The electron source may comprise an electron gun.

The electron gun may be a high-pressure electron gun. The electron gun may be operable to work in a working environment having a pressure of the order of 1-100 Pa.

The apparatus may further comprise a scanning mechanism operable to move at least one of the electron source and the support such that electrons emitted by the electron source can be directed at a range of different parts of a pellicle of a reticle and pellicle assembly when supported by the support.

For example an electron gun may be provided that can be moved relative to the support so as to scan an electron beam output by the electron gun over a surface of the pellicle of a reticle and pellicle assembly when supported by the support. This may allow a commercially available electron source to treat substantially the full area of the pellicle.

The apparatus may further comprise electron optics arranged to receive an electron beam from the electron source and to distribute the electron beam over a surface of the pellicle of a reticle and pellicle assembly when supported by the support.

The electron optics may comprise electrostatic focusing optics. The electron optics may be operable to distribute the electron beam substantially homogenously over a surface of the pellicle of a reticle and pellicle assembly when supported by the support. That is, the electron optics may be arranged to provide a uniform irradiation of the full area of a reticle and pellicle assembly.

According to a second aspect of the invention as defined by the appended dependent claim 14, there is provided a lithographic apparatus.

The lithographic apparatus may form part of a lithographic system together with a radiation source. The radiation source may be configured to generate an extreme ultraviolet (EUV) radiation beam. The lithographic apparatus may comprise: an illumination system, a support structure configured to support a reticle and pellicle assembly, a projection system and a substrate table configured to support a substrate. The illumination system may be configured to condition a radiation beam (received from a radiation source) before it is incident upon the reticle. The projection system is configured to project the radiation beam (now patterned by the reticle) onto the substrate.

The lithographic apparatus according to the second aspect of the present invention is particularly advantageous since it allows reticle and pellicle assemblies to be processed using the apparatus according to the first aspect whilst in the controlled environment of the lithographic apparatus. This avoids the need to remove the reticle and pellicle assembly from the lithographic apparatus, process it to reduce any partial oxidization, and then replace the reticle and pellicle assembly back in the lithographic apparatus. Each time a reticle and pellicle assembly is exposed to air or any environment with a significant content of oxygen and/or water it may be desirable to reduce any partial oxidization to avoid reflectivity variations.

The apparatus may be provided in a reticle library of the lithographic apparatus or on a reticle exchange device arm of the lithographic apparatus.

According to a third aspect of the invention as defined by the appended dependent claim 15, there is provided a reticle and pellicle assembly wherein the reticle and pellicle assembly further comprises a pellicle frame arranged to support the pellicle, the pellicle frame being arranged to engage with the reticle such that the pellicle is disposed adjacent the reticle; wherein the pellicle comprises a central pellicle membrane surrounded by a pellicle border; and wherein the pellicle frame comprises wall portions arranged to provide a generally rectangular body surrounding a generally rectangular aperture and wherein the wall portions are provided with at least one channel from an exterior surface of the wall portion to an interior surface of the wall portion adjacent the generally rectangular aperture, the at least one channel being non-linear wherein the at least one channel optionally defines a convoluted or labyrinth flow path from the exterior surface of the wall portion to the interior surface of the wall portion adjacent the generally rectangular aperture.

The assembly according to the third aspect of the invention is advantageous, as now discussed.

The pellicle frame may be adhered to or otherwise mechanically attached to the border of the pellicle, which it supports (for example under a pre-tension). When the pellicle frame is engaged with the reticle, the wall portions of the pellicle frame are adjacent a non-image formation portion of the reticle. In addition to supporting the pellicle, the pellicle frame generally surrounds a volume defined between the reticle and the pellicle. This is advantageous since it can limit the amount of particulate debris that can enter the volume defined between the reticle and the pellicle, preventing debris from impinging on the reticle (which could form errors in an image of the reticle formed on a substrate). However, when the assembly is being processed (for example, using the apparatus according to the first aspect of the invention) to reduce any oxidization on surfaces of the reticle and pellicle, the presence of the frame means that water and/or oxygen released from the reticle front side and pellicle back side cannot easily exit the volume between the pellicle and the reticle (typically only a very narrow slit is provided between the pellicle frame and reticle front side). Furthermore, any oxygen and water trapped between the pellicle membrane and the reticle front side can be re-captured (re-oxidizing the reticle and pellicle or getting adsorbed), extending the time of transmission recovery. Since there are surface oxides on both the pellicle (front side and back side) and the reticle (front side) the transmission of the whole system varies by a factor of 2-3 more than a pellicle-free system. The time taken for a pelliclized reticle to reach a steady state is of the order of 10-100 times greater than for a pellicle-free reticle. As a result, the transmission may drift for of the order of 2-20 wafers before reaching the steady-state. This is a significant loss of productivity.

However, the provision of at least one non-linear channel from an exterior surface of the wall portion to an interior surface of the wall portion adjacent the generally rectangular aperture can provide better fluid communication between the volume defined between the reticle and the pellicle and the surrounding environment. For example, the at least one channel can increase a fluid conductance between the volume defined between the reticle and the pellicle and the surrounding environment for a molecular flow of water vapor. Since it is non-linear, the at least one channel can prevent ballistic particle transport through the at least one channel (for example during pump down and vent of the assembly).

The at least one channel may accelerate gas exchange between the volume defined between the reticle and the pellicle and the surrounding environment and therefore speed up water removal from the annealed pelliclized reticle either during processing using the apparatus according to the first aspect of the invention or in use during EUV exposure within a lithographic exposure process.

The at least one channel may define a convoluted or labyrinth flow path from the exterior surface of the wall portion to the interior surface of the wall portion adjacent the generally rectangular aperture.

At least one channel may be provided on each of two opposed wall portions from an exterior surface of the wall portions to an interior surface of the wall portions.

Advantageously, such an arrangement provides a suitable arrangement to provide a flow of hydrogen between the pellicle and the reticle. The at least one channel on one wall portion may form an inlet for such a flow and the opposed wall portion may form an outlet for such a flow. This allows the flow to be substantially in one direction and may, for example, be referred to as a cross-flow. Advantageously, this can refresh gas in the volume between the reticle and the pellicle and therefore accelerate water removal and reduce residence time for water molecules (generated during reduction by active species) on and between critical surfaces. Pellicles can typically withstand up to 100 Pa overpressure, thus a significant flow can be provided with a pressure difference across the pellicle around 10-50 Pa (allowing a factor of 2 margin for safety). In some embodiments, hydrogen may even be provided between the reticle and the pellicle at pressures of the order of 10-100 Pa.

The at least one channel may increase a fluid conductance between a volume defined between the reticle and the pellicle and a surrounding environment by factor of at least 10.

It will be appreciated that as used in this context the fluid conductance between two volumes is a measure of how easily gas flows between those two volumes. For example, the fluid conductance may be proportional to a ratio of a total throughput of gas between the two volumes to a pressure differential across the two volumes.

The at least one channel may provide a sufficiently high fluid conductance between a volume defined between the reticle and the pellicle and a surrounding environment to allow the gas between the reticle and the pellicle to be replaced in a time of the order of 10 seconds or less. The volume between the reticle and the pellicle may have dimensions of the order of 2 mm x 15 cm x 15 cm. That is, the volume may be of the order of 0.045 liters. Therefore, if this gas were to be replaced in 10 seconds, this may correspond to an actual flow rate of 0.27 l/min. If the gas is at a pressure of 10 Pa, this is equivalent to a normal flow rate of 0.027 normal ml/min. For a channel having dimensions 1 mm x 1 mm, this is equivalent to a flow speed of 4.5 m/s. Preferably, the at least one channel may provide a sufficiently high fluid conductance between a volume defined between the reticle and the pellicle and a surrounding environment to allow a flow of at least 0.01 normal ml/min. More preferably, the at least one channel may provide a sufficiently high fluid conductance between a volume defined between the reticle and the pellicle and a surrounding environment to allow a flow of at least 0.03 normal ml/min and, more preferably, at least 0.3 normal ml/min to provide a faster removal of water vapor. Preferably, in use, the normal flow rate between the volume defined between the reticle and the pellicle and the surrounding environment is less than 5 normal ml/min in order to avoid overpressure on the pellicle and risk of pellicle rupture.

As stated above, for a volume defined between the reticle and the pellicle and a surrounding environment of the order of 0.045 liters to be replaced in a time of the order of 10 seconds or less, for a channel having dimensions 1 mm x 1 mm the flow speed is of the order of 4.5 m/s. This should result in good mixing/vorticity in the gas between the reticle and the pellicle. Preferably the fluid jet speed is less than 100 m/s, more preferably less than 10 m/s. Preferably the fluid jet speed is at least 1 m/s, such as 3 m/s or more. Such a jet will provide good mixing/vorticity in the gas between the pellicle and the reticle. However, the desired speed value may vary depending on the number of flow channels and the dimensions of the channels. It will be appreciated that in order to achieve higher flow rates, whilst maintaining the flow speed within a desired range, more channels may be provided, or the dimensions of the channel(s) may be increased.

A conducting coating may be provided on at least a part of the pellicle.

For example, a conducting coating may be provided on a border of the pellicle, optionally extending to the membrane of the pellicle but not obstructing EUV irradiation of a quality area of the reticle. The conducting coating may be provided on a front side of the pellicle border.

According to a fourth aspect of the invention there is provided a system comprising: an apparatus according to the first aspect of the invention; and at least one assembly according to the third aspect of the invention.

According to a fifth aspect there is provided a method for processing a reticle and pellicle assembly for a lithographic apparatus, the method comprising: providing a reticle and pellicle assembly; supporting the reticle and pellicle assembly; supplying hydrogen in the vicinity of the reticle and pellicle assembly; and directing electrons so as to be incident on the pellicle of the reticle and pellicle assembly such that at least a portion of the incident electrons propagate through the pellicle towards the reticle of the reticle and pellicle assembly.

The method according to the fifth aspect allows a reticle and pellicle assembly to be reduced, since the at least a portion of the incident electrons that propagate through the pellicle to the reticle can interact with the hydrogen supplied in the vicinity of the reticle and pellicle assembly to create active species, such as $H^*$, $H^+$, $H_2^+$, $H_3^+$. These active species can reduce (partially) oxidized surfaces, such as reticle front side, and/or promote adsorbed oxygen desorption.

The method may be carried out using an apparatus according to the first aspect of the invention.

The reticle and pellicle assembly may be an assembly according to the third aspect of the invention.

The hydrogen may be directed between the reticle and the pellicle of the reticle and pellicle assembly when supported by the support.

That is, the hydrogen is provided as a flow of hydrogen between the pellicle and the reticle. Such a flow may be substantially in one direction and may, for example, be referred to as a cross-flow. Advantageously, this can refresh gas in the volume between the reticle and the pellicle and therefore accelerate water removal and reduce residence time for water molecules (generated during reduction by active species) on and between critical surfaces. Pellicles can typically withstand up to 100 Pa overpressure, thus a significant flow can be provided with a pressure difference across the pellicle around 10-50 Pa (allowing a factor of 2 margin for safety). In some embodiments, hydrogen may even be provided between the reticle and the pellicle at pressures of the order of 10-100 Pa.

The hydrogen may be supplied at a pressure in the range 50 to 100 Pa.

With such an arrangements, the hydrogen pressure between the pellicle and reticle (and, optionally above a front surface of the pellicle) may be boosted from a typical value of 5-10 Pa within an EUV lithographic apparatus. Advantageously, this can increase generation of active species under the irradiation from the electron source and/or DUV or VUV radiation that may be emitted as Bremsstrahlung radiation.

The method may further comprise controlling a temperature of the reticle and pellicle assembly. It will be appreciated that this may involve heating or cooling of the reticle and pellicle assembly.

The method may further comprise providing the reticle and pellicle assembly with an electron sink.

The method may further comprise providing an electrical connection between the reticle front surface and the pellicle membrane.

Advantageously, this can reduce any biasing voltage across the reticle and pellicle (which could exert electrostatic pressure on the pellicle).

The portion of incident electrons which propagates through the pellicle may have an energy of less than 500 eV.

In some embodiments, the portion of incident electrons which propagates through the pellicle has an energy of less than 100 eV. This may ensure that the pellicle does not rupture due to electrostatic attraction to the reticle (pellicles are known to break, if there is a voltage drop to reticle of the order of 200 V).

The method may further comprise directing electromagnetic radiation at the pellicle to provide a photo-current to the pellicle to at least partially compensate for the charging by the electron source.

The portion of incident electrons which propagates through the pellicle may have a sufficient energy to achieve a secondary electron yield of greater than 1 at the reticle.

This may be achieved if the electrons, once attenuated by the pellicle, have an energy of approximately 100-300 eV. Advantageously, with such an arrangement any biasing voltage across the reticle and the pellicle may be minimized whilst only the pellicle is grounded.

The method may comprise providing an enclosure within which the reticle and pellicle assembly is supported and within which the hydrogen is supplied.

Directing electrons so as to be incident on the pellicle of the reticle and pellicle assembly such that at least a portion of the incident electrons propagate through the pellicle towards the reticle of the reticle and pellicle assembly may comprise scanning a beam of electrons over a surface of the reticle and pellicle assembly.

Directing electrons so as to be incident on the pellicle of the reticle and pellicle assembly such that at least a portion of the incident electrons propagate through the pellicle towards the reticle of the reticle and pellicle assembly may comprise distributing an electron beam over a surface of the pellicle of a reticle and pellicle assembly.

This may be achieved using electron optics. The electron optics may comprise electrostatic focusing optics. The electron optics may be operable to distribute the electron beam substantially homogenously over a surface of the pellicle of a reticle and pellicle assembly when supported by the support. That is, the electron optics may be arranged to provide a uniform irradiation of the full area of a reticle and pellicle assembly.

According to a sixth aspect outside the scope of the present invention there is provided: an apparatus comprising: a support for supporting an object; a hydrogen supply operable to supply hydrogen in the vicinity of an object when supported by the support; and a magnetic field generator operable to generate a magnetic field in the vicinity of an object when supported by the support.

The apparatus according to the sixth aspect is advantageous as now discussed. The apparatus may be provided within an EUV lithographic apparatus. The support may be a reticle stage. The object may be a reticle and pellicle assembly.

The object may have a surface that faces away from the support. The hydrogen supply may be operable to supply hydrogen in the vicinity of this surface of the object when supported by the support. The magnetic field generator may be operable to generate a magnetic field in the vicinity of this surface of the object when supported by the support.

The hydrogen supply can have a cleaning effect on the surfaces of the object (for example a reticle and pellicle assembly). The flow of hydrogen may reduce an amount of debris that is incident on the surfaces of the object. The apparatus may have application within an EUV lithographic apparatus and, in the presence of EUV radiation, the hydrogen gas from the hydrogen supply may form a plasma in the vicinity of the object. This plasma will have a cleaning effect on the surfaces of the object, reacting with oxygen on the surfaces of the object (so as to reduce said surfaces) and reacting with debris on said surfaces so as to aid the removal of such debris.

Pellicles for use in an EUV lithographic apparatus are typically formed from silicon and carbon compounds. These materials suffer from Hydrogen Induced Outgassing (HIO). Through a few reaction steps, hydrogen removes the (native) oxide shell of such pellicles, and then the silicon or carbon core. For silicon-based pellicles, this etching of the silicon core by the hydrogen plasma forms silane $SiH_4$ whereas for carbon-based pellicles this etching of the carbon core by the hydrogen plasma forms methane compounds. To prevent or reduce this plasma etching, it may be desirable to develop etch resistant capping materials that can protect the pellicle. However, it is not trivial to find such capping materials that are sufficiently impermeable to hydrogen.

The plasma that etches the pellicle comprises hydrogen ions and electrons. Advantageously, the magnetic field source of the apparatus according to the sixth aspect is operable to act on these charged particles via the Lorentz force and, in so doing, can direct these charged particles (and in particular the hydrogen ions) away from the surface of the pellicle. Advantageously, this can reduce the plasma etching rate and so extend the lifetime of the pellicle.

The magnetic field generator may be operable to generate a magnetic field in the vicinity of an object when supported by the support wherein a strength of the magnetic field decreases in a direction generally perpendicular to and away from a surface of the object when supported by the support.

For example, the magnetic field generator may comprise one or more dipole magnets arranged such that the dipole axes or planes of said dipole magnets are perpendicular to the surface of the object when supported by the support. Said one or more dipole magnets may be disposed at or behind the surface of the object when supported by the support. With such an arrangement, the magnetic field lines will have a component that is parallel to the surface of the object when supported by the support.

Advantageously, by creating a magnetic field which decreases in a direction generally perpendicular to and away from a surface of the object when supported by the support, as a particle moves towards the surface of the object it will experience an increased magnetic field. In turn, the velocity of the particle perpendicular to the magnetic field increases and the velocity of the particle parallel to the magnetic field decreases. For at least some fraction of charged particles, the velocity of the particle parallel to the magnetic field will fall to zero and the particle will reverse direction. Such an arrangement is known as a magnetic mirror.

The magnetic field generator may comprise a coil and a power supply operable to generate a current in the coil. A plane of the coil may be generally parallel to a plane of the support and any object supported by the support.

The coil may generally surround the support and/or object supported by the support. With such an arrangement, the magnetic field will be symmetric about a line or axis that is generally perpendicular to and passes through the center of the coil and the magnetic field strength will decrease in a direction generally perpendicular to and away from a surface of the object when supported by the support.

The magnetic field generator may comprise a plurality of magnets distributed over a plane of the support. Each of the plurality of magnets may have a dipole orientated generally perpendicular to a plane of the support and any object supported by the support.

Each magnet may be elongate in a direction perpendicular to its dipole moment.

With such an arrangement, each magnet will produce a magnetic field which will be locally symmetric about a plane that is generally parallel to the dipole moment of that magnet and which has a magnetic field strength that will decrease in a direction generally perpendicular to and away from a surface of the object when supported by the support.

The dipole moments of each pair of adjacent magnets of the plurality of magnets distributed over a plane of the support may be anti-parallel.

With such an arrangement, the magnetic field lines from each magnet will extend to or from the adjacent magnets (of opposite polarity) and the magnetic field strength will decrease in a direction generally perpendicular to and away from a surface of the object when supported by the support. There will be a magnetic field cusp adjacent to each of the magnets.

The magnetic field generator may be operable to generate a magnetic field in the vicinity of an object when supported by the support wherein the magnetic field is generally parallel to a plane of the object when supported by the support.

With this arrangement, as charged particles propagate through the magnetic field towards a surface of the object, they will tend towards a helical path within the magnetic field. Advantageously, at least a portion of such particles will be trapped in this helical path within the magnetic field and will not be incident on the surface of the object.

The magnetic field strength of the magnetic field (which is generally parallel to the surface of the object when supported by the support) may be generally uniform.

The magnetic field generator may comprise a pair of opposed coils, a plane of each coil being generally perpendicular to the plane of the object when supported by the support.

The magnetic field generator may further comprise one or more power supplies arranged to generate a current in each of the pair of opposed coils.

The pair of coils may be generally circular or square. The pair of opposed coils may be generally of the form of Helmholtz coils.

The magnetic field generator may comprise a power supply that is arranged to generate a current through a plasma formed from the hydrogen supplied by the hydrogen supply.

The plasma may, for example, be formed in the vicinity of the object by EUV radiation passing through the hydrogen gas. As the power supply passes a current through the plasma, the plasma will contract in dimensions perpendicular to the current density vector. This is known as Z-pinch confinement.

The magnetic field generator may comprise two electrodes disposed in the plasma and the power supply may be operable to apply a voltage across the two electrodes. That is, there may be direct contact between the power supply and the plasma. Alternatively, the power supply may be inductively coupled to the plasma and may be arranged to induce a current in the plasma.

The magnetic field generator may be operable to generate a magnetic field in the vicinity of an object when supported by the support having a magnetic field strength of 0.2 T or greater.

According to a seventh aspect there is provided a lithographic apparatus comprising the apparatus according to the sixth aspect wherein the support is for supporting a reticle and pellicle assembly.

For embodiments wherein the magnetic field generator comprises a pair of opposed coils, a plane of each coil being generally perpendicular to a plane of the object when supported by the support, the pair of opposed coils may be disposed on reticle masking blades of the lithographic apparatus.

According to an eighth aspect outside the scope of the present invention there is provided a method comprising: supporting an object; generating a hydrogen plasma in the vicinity of a surface of an object; and generating a magnetic field in the vicinity of the surface of the object, the magnetic field arranged to reduce a flux of charged particles from the plasma that is incident on the surface of the object.

The method according to the eighth aspect is advantageous as now discussed. The method may have application within an EUV lithographic apparatus. The object may be a reticle and pellicle assembly. The hydrogen plasma can have a cleaning effect on the surface of the object (for example a reticle and pellicle assembly). However, objects formed from silicon and carbon compounds (such as pellicles for use in an EUV lithographic apparatus) suffer from Hydrogen Induced Outgassing (HIO). Through a few reaction steps, hydrogen plasma can remove the (native) oxide shell of such objects, and then the silicon or carbon core. For silicon-based pellicles, this etching of the silicon core by the hydrogen plasma forms silane $SiH_4$ whereas for carbon-based pellicles this etching of the carbon core by the hydrogen plasma forms methane compounds.

Advantageously, by generating a magnetic field in the vicinity of the surface of the object that is arranged to reduce a flux of charged particles from the plasma that is incident on the surface of the object, the plasma etching rate is reduced and so the lifetime of the object is extended. It will be appreciated that the magnetic field acts on the charged particles in the plasma via the Lorentz force and, in so doing, can direct these charged particles (and in particular the hydrogen ions) away from the surface of the pellicle.

Generating a hydrogen plasma in the vicinity of the surface of the object may comprise supplying hydrogen in the vicinity of the surface of the object and irradiating the hydrogen with EUV radiation so as to form a plasma.

A strength of the generated magnetic field may decrease in a direction generally perpendicular to and away from the surface of the object.

Advantageously, by creating a magnetic field which decreases in a direction generally perpendicular to and away from the surface of the object, as a particle moves towards the surface of the object it will experience an increased magnetic field. In turn, the velocity of the particle perpendicular to the magnetic field increases and the velocity of the particle parallel to the magnetic field decreases. For at least some fraction of charged particles, the velocity of the particle parallel to the magnetic field will fall to zero and the particle will reverse direction. Such an arrangement is known as a magnetic mirror.

The magnetic field may be generated by a coil and a power supply operable to generate a current in the coil, and a plane of the coil may be generally parallel to a plane of the surface of the object.

The coil may generally surround the object and/or a support for supporting the object. With such an arrangement, the magnetic field will be symmetric about a line or axis that is generally perpendicular to and passes through the center of the coil and the magnetic field strength will decrease in a direction generally perpendicular to and away from the surface of the object.

The magnetic field may be generated by a plurality of magnets disposed on an opposite side of the object to the surface of the object and distributed over a plane which is parallel to the surface of the object. Each magnet may have a dipole orientated generally perpendicular to a plane of the surface of the object.

Each magnet may be elongate in a direction perpendicular to its dipole moment. With such an arrangement, each magnet will produce a magnetic field which will be locally symmetric about a plane that is generally parallel to the dipole moment of that magnet and which has a magnetic field strength that will decrease in a direction generally perpendicular to and away from the surface of the object.

The dipole moments of each pair of adjacent magnets of the plurality of magnets may be anti-parallel.

With such an arrangement, the magnetic field lines from each magnet will extend to or from the adjacent magnets (of opposite polarity) and the magnetic field strength will decrease in a direction generally perpendicular to and away from the surface of the object. There will be a magnetic field cusp adjacent to each of the magnets.

The generated magnetic field may be generally parallel to the surface of the object.

With this arrangement, as charged particles propagate through the magnetic field towards the surface of the object, they will tend towards a helical path within the magnetic field. Advantageously, at least a portion of such particles will be trapped in this helical path within the magnetic field and will not be incident on the surface of the object.

The magnetic field strength of the magnetic field (which is generally parallel to the surface of the object) may be generally uniform.

The magnetic field may be generated by a pair of opposed coils, a plane of each coil extending being generally perpendicular to the surface of the object.

The pair of coils may be generally circular or square. The pair of opposed coils may be generally of the form of Helmholtz coils.

The magnetic field may be generated by generating a current through the plasma in the vicinity of a surface of an object.

As current passes through the plasma, the plasma will contract in dimensions perpendicular to the current density vector. This is known as Z-pinch confinement.

The generated magnetic field may have a magnetic field strength of 0.2 T or greater.

It will be appreciated that one or more aspects or features described above or referred to in the following description may be combined with one or more other aspects or features.

BRIEF DESCRIPTION OF THE DRAWINGS

Embodiments and embodiments of the invention will now be described, by way of example only, with reference to the accompanying schematic drawings, in which:

- Figure 1 is a schematic illustration of a lithographic system comprising a lithographic apparatus and a radiation source;
- Figure 2 shows a first embodiment of the invention of an apparatus for processing a reticle and pellicle assembly;
- Figure 3 shows a second embodiment of the invention of an apparatus for processing a reticle and pellicle assembly;
- Figures 4A and 4B show two mutually orthogonal cross sectional views of a known reticle and pellicle assembly;
- Figures 5A and 5B show two mutually orthogonal cross sectional views of a new reticle and pellicle assembly;
- Figure 6 is a schematic illustration of an apparatus according to an embodiment that uses magnetic fields to reduce a flux of charged particles from a plasma that is incident on the surfaces of an object;
- Figure 7A is a schematic illustration of another apparatus according to an embodiment that uses magnetic fields to reduce a flux of charged particles from a plasma that is incident on the surfaces of an object;
- Figure 7B is a schematic plan view of the part of the apparatus shown in Figure 7A showing the positions of a plurality of magnets relative to a plane of a reticle; and
- Figure 8 is a schematic illustration of another apparatus according to an embodiment that uses magnetic fields to reduce a flux of charged particles from a plasma that is incident on the surfaces of an object.

DETAILED DESCRIPTION

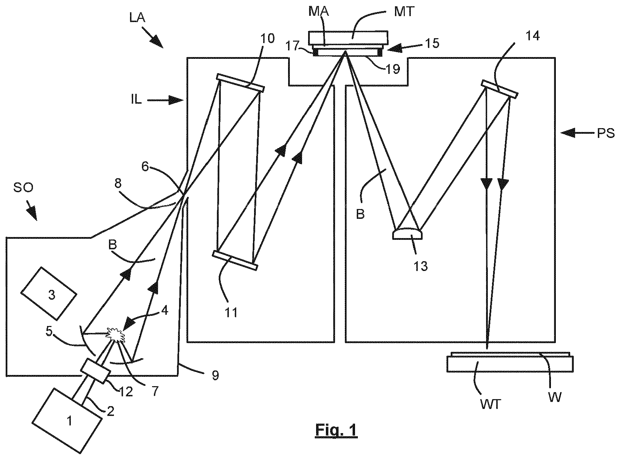

Figure 1 shows a lithographic system. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a reticle assembly 15 including a patterning device MA (e.g., a reticle or mask), a projection system PS and a substrate table WT configured to support a substrate W. The illumination system IL is configured to condition the radiation beam B before it is incident upon the patterning device MA. The projection system is configured to project the radiation beam B (now patterned by the patterning device MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g., hydrogen) may be provided in the radiation source SO. A vacuum may be provided in the illumination system IL and/or the projection system PS. A small amount of gas (e.g., hydrogen) at a pressure well below atmospheric pressure may be provided in the illumination system IL and/or the projection system PS.

The radiation source SO shown in Figure 1 is of a type that may be referred to as a laser produced plasma (LPP) source. A laser 1, which may for example be a $CO_2$ laser, is arranged to deposit energy via a laser beam 2 into a fuel, such as tin (Sn) that is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, e.g., in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure that is arranged to reflect EUV radiation (e.g., EUV radiation having a desired wavelength such as 13.5 nm). The collector 5 may have an elliptical configuration, having two ellipse focal points. A first focal point may be at the plasma formation region 4, and a second focal point may be at an intermediate focus 6, as discussed below.

In other embodiments of a laser produced plasma (LPP) source the collector 5 may be a so-called grazing incidence collector that is configured to receive EUV radiation at grazing incidence angles and focus the EUV radiation at an intermediate focus. A grazing incidence collector may, for example, be a nested collector, comprising a plurality of grazing incidence reflectors. The grazing incidence reflectors may be disposed axially symmetrically around an optical axis.

The radiation source SO may include one or more contamination traps (not shown). For example, a contamination trap may be located between the plasma formation region 4 and the radiation collector 5. The contamination trap may for example be a rotating foil trap, or may be any other suitable form of contamination trap.

The laser 1 may be separated from the radiation source SO. Where this is the case, the laser beam 2 may be passed from the laser 1 to the radiation source SO with the aid of a beam delivery system (not shown) comprising, for example, suitable directing mirrors and/or a beam expander, and/or other optics. The laser 1 and the radiation source SO may together be considered to be a radiation system.

Radiation that is reflected by the collector 5 forms a radiation beam B. The radiation beam B is focused at point 6 to form an image of the plasma formation region 4, which acts as a virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source SO.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the reticle assembly 15 held by the support structure MT. The reticle assembly 15 includes a patterning device MA and a pellicle 19. The pellicle is mounted to the patterning device MA via a pellicle frame 17. The reticle assembly 15 may be referred to as a reticle and pellicle assembly 15. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 that are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system PS may include any number of mirrors (e.g., six mirrors).

The lithographic apparatus may, for example, be used in a scan mode, wherein the support structure (e.g., mask table) MT and the substrate table WT are scanned synchronously while a pattern imparted to the radiation beam is projected onto a substrate W (i.e., a dynamic exposure). The velocity and direction of the substrate table WT relative to the support structure (e.g., mask table) MT may be determined by the demagnification and image reversal characteristics of the projection system PS. The patterned radiation beam that is incident upon the substrate W may comprise a band of radiation. The band of radiation may be referred to as an exposure slit. During a scanning exposure, the movement of the substrate table WT and the support structure MT may be such that the exposure slit travels over an exposure field of the substrate W.

The radiation source SO and/or the lithographic apparatus that is shown in Figure 1 may include components that are not illustrated. For example, a spectral filter may be provided in the radiation source SO. The spectral filter may be substantially transmissive for EUV radiation but substantially blocking for other wavelengths of radiation such as infrared radiation.

In other embodiments of a lithographic system the radiation source SO may take other forms. For example, in alternative embodiments the radiation source SO may comprise one or more free electron lasers. The one or more free electron lasers may be configured to emit EUV radiation that may be provided to one or more lithographic apparatus.

As was described briefly above, the reticle assembly 15 includes a pellicle 19 that is provided adjacent to the patterning device MA. The pellicle 19 is provided in the path of the radiation beam B such that radiation beam B passes through the pellicle 19 both as it approaches the patterning device MA from the illumination system IL and as it is reflected by the patterning device MA towards the projection system PS. The pellicle 19 comprises a thin film or membrane that is substantially transparent to EUV radiation (although it will absorb a small amount of EUV radiation). By EUV transparent pellicle or a film substantially transparent for EUV radiation herein is meant that the pellicle 19 is transmissive for at least 65% of the EUV radiation, preferably at least 80% and more preferably at least 90% of the EUV radiation. The pellicle 19 acts to protect the patterning device MA from particle contamination.

Whilst efforts may be made to maintain a clean environment inside the lithographic apparatus LA, particles may still be present inside the lithographic apparatus LA. In the absence of a pellicle 19, particles may be deposited onto the patterning device MA. Particles on the patterning device MA may disadvantageously affect the pattern that is imparted to the radiation beam B and therefore the pattern that is transferred to the substrate W. The pellicle 19 advantageously provides a barrier between the patterning device MA and the environment in the lithographic apparatus LA in order to prevent particles from being deposited on the patterning device MA.

The pellicle 19 is positioned at a distance from the patterning device MA that is sufficient that any particles that are incident upon the surface of the pellicle 19 are not in a field plane of the lithographic apparatus LA. This separation between the pellicle 19 and the patterning device MA acts to reduce the extent to which any particles on the surface of the pellicle 19 impart a pattern to the radiation beam B that is imaged onto the substrate W. It will be appreciated that where a particle is present in the beam of radiation B, but at a position that is not in a field plane of the beam of radiation B (for example not at the surface of the patterning device MA), then any image of the particle will not be in focus at the surface of the substrate W. In the absence of other considerations it may be desirable to position the pellicle 19 a considerable distance away from the patterning device MA. However, in practice the space which is available in the lithographic apparatus LA to accommodate the pellicle is limited due to the presence of other components. In some embodiments, the separation between the pellicle 19 and the patterning device MA may, for example, be approximately between 1 mm and 10 mm, for example between 1 mm and 5 mm, for example between 2 mm and 2.5 mm.

The pellicle may comprise a border portion and a membrane. The border portion of the pellicle may be hollow and generally rectangular and the membrane may be bounded by the border portion. As known in the art, the pellicle may be formed by deposition of one or more thin layers of material on a generally rectangular silicon substrate. The silicon substrate supports the one or more thin layers during this stage of the construction of the pellicle. Once a desired or target thickness and composition of layers has been applied, a central portion of the silicon substrate is removed by etching (this may be referred to as back etching). A peripheral portion of the rectangular silicon substrate is not etched (or alternatively is etched to a lesser extent than the central portion). This peripheral portion forms the border portion of the final pellicle while the one or more thin layers form the membrane of the pellicle (which is bordered by the border portion). The border portion of the pellicle may be formed from silicon.

Such a pellicle may require some support from a more rigid pellicle frame. The pellicle frame may provide two functions. First, the pellicle frame may support the pellicle and may also tension the pellicle membrane. Second, the pellicle frame may facilitate connection of the pellicle to a patterning device (reticle). It one known arrangement, the pellicle frame may comprise a main, generally rectangular body portion which is glued to the border portion of the pellicle and titanium attachment mechanisms that are glued to the side of this main body. Intermediate fixing members (known as studs) are affixed to the patterning device (reticle). The intermediate fixing members (studs) on the patterning device (reticle) may engage (for example releasably engage) with the attachment members of the pellicle frame.

A reticle assembly may be prepared for use in a lithographic apparatus by attaching a pellicle to a pellicle frame and by attaching the pellicle frame to a patterning device. A reticle assembly comprising a patterning device MA and a pellicle supported adjacent to the patterning device by a pellicle frame may be prepared remotely from a lithographic apparatus LA and the reticle assembly may be transported to the lithographic apparatus LA for use in the lithographic apparatus LA. For example, a pellicle frame supporting a pellicle may be attached to a patterning device, so as to form a reticle assembly, at a site at which a pattern is imparted onto the patterning device. The reticle assembly may then be transported to a separate site at which a lithographic apparatus LA is situated and the reticle assembly may be provided to the lithographic apparatus LA for use in the lithographic apparatus LA.

When a reticle assembly 15 is exposed to air, surfaces of the assembly will become partially oxidized. This partial oxidization affects the reflectivity of the reticle MA and the transmissivity of the pellicle 19, which is undesirable. Furthermore, the effect on the reflectivity will, in general, vary across the reticle MA and the effect on the transmissivity will, in general, vary across the pellicle 19. Within an EUV lithographic apparatus, hydrogen may be provided in the vicinity of the substrate table WT (also referred to as a reticle stage). For pellicle-free reticles, in the presence of the EUV radiation, this hydrogen gas will form a plasma which will act to reduce the partially oxidized surface of the reticle, returning the reflectivity to nominal and consistent levels. Typically, reflectivity of pellicle-free reticles drifts for a few dies when reticles previously exposed to air are first exposed to EUV and then reaches a steady state. The productivity loss of such a reflectivity drift may be of the order of 10s of minutes and may therefore be tolerable.

However, as discussed below, the reduction of partially oxidized surfaces in a reticle and pellicle assembly 15 is more challenging. Embodiments and embodiments of the present invention relate an apparatus and associated methods for processing a reticle and pellicle assembly 15 for use within an extreme ultraviolet (EUV) lithographic apparatus, in particular to reduce such reticle and pellicle assembly 15 and remove oxidization therefrom. Embodiments and embodiments of the present invention also relate to a reticle and pellicle assembly 15 that may be particularly suitable for use in such apparatus and method for processing a reticle and pellicle assembly 15.

For reticle and pellicle assemblies 15 (also known as pelliclized reticles) the flux of active species from the hydrogen plasma that is incident on the front surface of the reticle MA and the opposed surface of the pellicle 19 is significantly reduced. This is because the pellicle 19 membrane forms a barrier for species generated in EUV beam next to pellicle 19 front side. Further, active species generated in the volume between the reticle MA and pellicle 19 will be partially quenched (recombined, associated) at the surfaces of reticle MA and pellicle 19 and this effect further reduces the flux of active species available for oxygen abstraction.

In addition, water and/or oxygen released from the reticle MA front side and pellicle 19 rear side cannot easily exit the volume between the pellicle 19 and the reticle MA (typically only a very narrow slit is provided between the pellicle frame and reticle MA front side). Furthermore, any oxygen and water trapped between pellicle membrane and reticle MA front side can be re-captured (re-oxidizing the reticle MA and pellicle 19 or getting adsorbed), extending the time of transmission recovery. Since there are surface oxides on both the pellicle 19 (front side and back side) and the reticle MA (front side) the transmission of the whole system varies by a factor of 2-3 more than a pellicle-free system. The time taken for a pelliclized reticle to reach a steady state is of the order of 10-100 times greater than for a pellicle-free reticle. As a result, the transmission may drift for of the order of 2-20 wafers before reaching the steady-state. This is a significant loss of productivity.

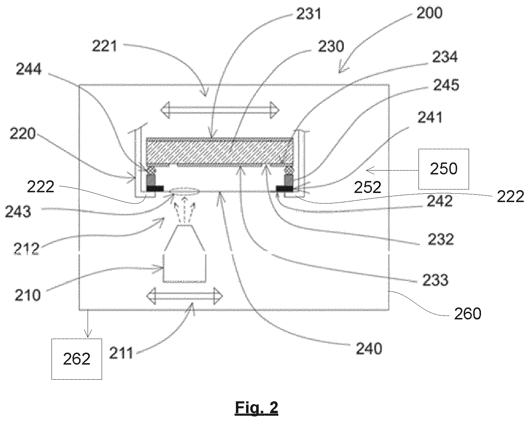

Figure 2 shows a first embodiment of an apparatus 200 for processing a reticle and pellicle assembly. Also shown in Figure 2 is reticle and pellicle assembly being processed in the apparatus 200.

The apparatus comprises a support 220, a hydrogen supply 250 and an electron source 210.

The support 220 is for supporting a reticle and pellicle assembly. In Figure 2, a reticle and pellicle assembly being is shown supported by the support 220.

The reticle and pellicle assembly comprises a reticle and a pellicle.

The reticle comprises a reticle substrate 230 having a front side and rear side 231. The front side is provided with a central quality area 233 (also referred to as an image formation portion), which is surrounded by a peripheral non-imaged area 234. The central quality area 233 and the peripheral non-imaged area 234 may each comprise a multi-layer mirror disposed on the reticle substrate. Said multilayer mirror may be arranged to reflect EUV radiation. It will be appreciated that the central quality area 233 may also be provided with a patterned absorbing layer over the multilayer mirror (so as to form a pattern imparted to a beam of EUV radiation reflected from the central quality area 233 in use). The central quality area 233 and the peripheral non-imaged area 234 are separated by a black border 232 (typically comprising non-reflective material).

The pellicle comprises a pellicle membrane 240 surrounded by a pellicle border 241. The pellicle is supported by a pellicle frame 245. For example, the pellicle border 241 may be adhered to the pellicle frame 245, for example with the pellicle membrane 240 under tension.

The pellicle frame 245 is connected to the non-imaged area 234 of the reticle to facilitate connection of the pellicle to the reticle. This connection is shown rather schematically as connection 244. It will be appreciated that the pellicle frame 245 may comprise attachment mechanisms and that intermediate fixing members (known as studs) may be affixed to the non-imaged area 234 of the reticle. The intermediate fixing members (studs) on the reticle may engage (for example releasably engage) with the attachment members of the pellicle frame 245 to provide connections 244.

The reticle and pellicle assembly shown in Figure 2 may, in use, be mounted on the support structure MT show in Figure 1, for example after having been processed in apparatus 200.

The support 220 comprises a plurality of shelf portions 222 arranged such that the reticle and pellicle assembly can be supported thereon with the pellicle being in contact with said shelf portions in the vicinity of the pellicle border 245. The support 220 may comprise two such shelf portions 222 arranged to support opposite edges of the pellicle. Alternatively, the support 220 may comprise four such shelf portions 222 arranged to support all four edges of the pellicle.

The hydrogen supply 250 is operable to supply hydrogen 252 in the vicinity of to a pellicle of a reticle and pellicle assembly when supported by the support 220. Optionally, the apparatus 200 may further comprise an enclosure 260, the support 220 being disposed in the enclosure 260. The hydrogen supply 250 may be operable to supply hydrogen 252 to the enclosure. It will be appreciated that the enclosure may be provided with one or more pumps 262 (for example vacuum pumps). The hydrogen supply 250 and said pumps 262 may be used to control a pressure within the enclosure 260. The hydrogen supply 250 and said pumps 262 may be considered to form part of a pressure control system for the apparatus 200.

Alternatively, the apparatus 200 may have no enclosure but rather may be provided within a controlled environment within another apparatus. For example, the apparatus 200 may be provided within a part of a lithographic apparatus of the type shown in Figure 1.

The electron source 210 may comprise an electron gun. The electron gun may be a high-pressure electron gun. The electron gun may be operable to work in a working environment having a pressure of the order of 1-100 Pa.

The electron source 210 is operable to direct electrons 212 so as to be incident on the pellicle of a reticle and pellicle assembly when supported by the support 220. In particular, the electron source 210 is operable to direct electrons 212 at a portion 243 of the pellicle membrane 240.

The apparatus 200 further comprises a scanning mechanism operable to move at least one of the electron source 210 and the support 220. The electron source 210 may be movable in a plane generally parallel to the pellicle membrane 240 supported by the support 200, as indicated schematically by arrow 211. Although indicated by a single arrow 211 in Figure 2, it will be appreciated that, in general, the electron source 210 may be movable in two dimensions in the plane generally parallel to the pellicle membrane 240. Additionally or alternatively, the support 220 may be movable in a plane generally parallel to the pellicle membrane 240 supported by the support 220, as indicated schematically by arrow 221. Although indicated by a single arrow 221 in Figure 2, it will be appreciated that, in general, the support 220 may be movable in two dimensions in the plane generally parallel to the pellicle membrane 240. With such an scanning mechanism, that electrons 212 emitted by the electron source 210 can be directed at a range of different portions 243 of the pellicle of a reticle and pellicle assembly when supported by the support 220.

In one embodiment, an electron gun 210 may be provided that can be moved relative to the support 220 so as to scan an electron beam 212 output by the electron gun 210 over a surface of the pellicle of a reticle and pellicle assembly when supported by the support 220. This may allow a commercially available electron source to treat substantially the full area of the pellicle membrane 240.

The electron source 210 of the apparatus 200 shown in Figure 2 is operable to direct electrons 212 so as to be incident on a pellicle of a reticle and pellicle assembly when supported by the support 220. At least a portion of such incident electrons will propagate through the pellicle to the reticle. The electrons can interact with the hydrogen 252 from the hydrogen source 250 to create active species, such as $H^*$, $H^+$, $H_2^+$, $H_3^+$, which can reduce (partially) oxidized surfaces, such as reticle front side, and/or promote adsorbed oxygen desorption.

The apparatus 200 is further provided with an electron sink, as now discussed. In particular, a part of the support 220 which, in use, contacts the reticle and pellicle assembly comprises an electron sink. For example, the part of the support 220 (for example shelf portions 222) which, in use, contacts the reticle and pellicle assembly may be grounded. In this example, the part of the support 220 which, in use, contacts the reticle and pellicle assembly comprises shelve portions 222 which contact part of the pellicle. However, in general, the part of the support which, in use, contacts the reticle and pellicle assembly may contact part of the pellicle and/or part of the reticle. Such an electron sink may prevent the pellicle from accumulating sufficient charge so as to rupture due to electrostatic pressure or spark damage occurring to the reticle and/or pellicle. It may also prevent the pellicle from accumulating sufficient charge so as to influence subsequent electrons 212 emitted from the electron source 210.

In this embodiment, a conducting coating 242 is provided on part of the pellicle. For example, a conducting coating 242 is provided on a portion of the pellicle which includes a portion of the pellicle border 241. The conducting coating 242 also extends partially on to the pellicle membrane 240. However, the conducting coating 242 does not extend sufficiently far so as to obstruct the quality area 233 of the reticle (so as not to obstruct EUV irradiation the quality area 233 during a lithographic exposure). The conducting coating 233 is provided on a front side of the pellicle and contacts the support 220.

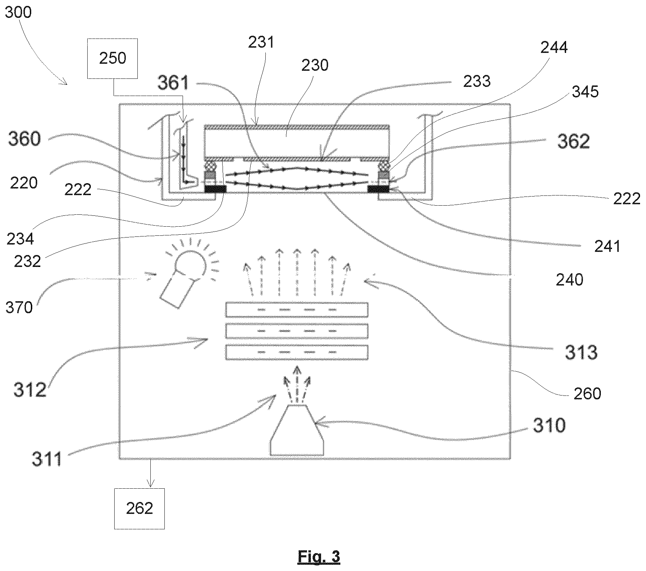

Figure 3 shows a second embodiment of an apparatus 300 for processing a reticle and pellicle assembly. Also shown in Figure 3 is reticle and pellicle assembly being processed in the apparatus 300. The apparatus 300 shown in Figure 3 shares many features in common with the apparatus 200 shown in Figure 2. Any such common features to both the apparatus 200 shown in Figure 2 and the apparatus 300 shown in Figure 3 share common reference numerals and will not be discussed in detail below. In the following, the differences between the apparatus 300 shown in Figure 3 and the apparatus 200 shown in Figure 2 will be described.

The apparatus comprises a support 220, a hydrogen supply 250 and an electron source 310.

The reticle and pellicle assembly comprises a reticle and a pellicle and is substantially as described above with reference to Figure 2 with the exception that the pellicle is connected to the reticle via a modified pellicle frame 345.

The hydrogen supply 250 is operable to supply hydrogen 252 in the vicinity of to a pellicle of a reticle and pellicle assembly when supported by the support 220. In particular, in this embodiment the hydrogen supply 250 comprises one or more nozzles 360 arranged to direct hydrogen between the reticle and the pellicle of the reticle and pellicle assembly when supported by the support 220. To facilitate this, the modified pellicle frame 345 is provided with one or more channels 362. The one or more channels 362 provide better fluid communication between the volume defined between the reticle and the pellicle and the surrounding environment. Each of the one or more nozzles 360 is adjacent one of these channels 362 and is arranged to direct hydrogen through said channel 362 between the reticle and the pellicle of the reticle and pellicle assembly when supported by the support 220. Such an arrangement of a nozzle 360 and an adjacent channel 362 may be considered to form an inlet into the volume defined between the reticle and the pellicle. In addition to such inlets, one or more channels 362 may be provided with no associated nozzle and these channels 362 may be considered to form an outlet from the volume defined between the reticle and the pellicle. The inlets may be arranged on one side of the reticle and pellicle assembly and the outlets may be arranged on an opposite side of the reticle and pellicle assembly.

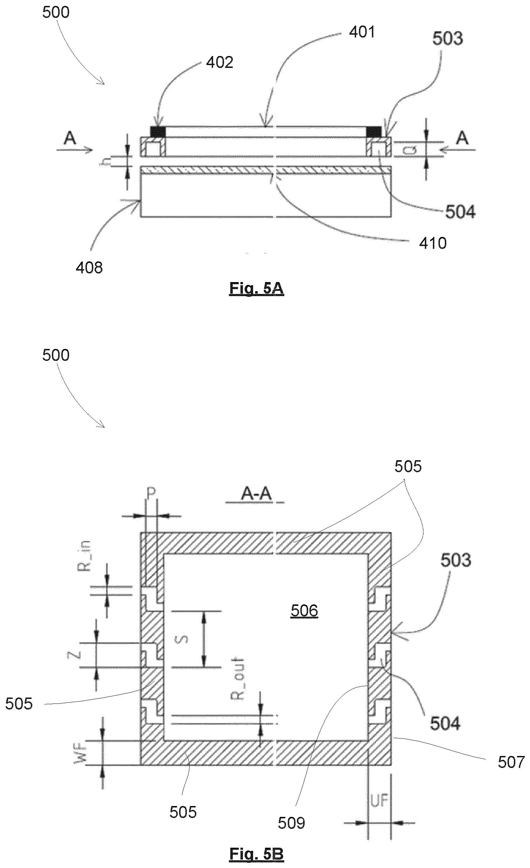

In one embodiment, the modified reticle frame 345 may be generally of the form of the reticle frame described below with reference to Figures 5A and 5B.

In this embodiment, the hydrogen supply 250 is operable to provide a flow of hydrogen 361 between the pellicle and the reticle (between the inlets and the outlets described above). Such a flow may be substantially in one direction and may, for example, be referred to as a cross-flow. Advantageously, this can refresh gas in the volume between the reticle and the pellicle and therefore accelerate water removal and reduce residence time for water molecules (generated during reduction by active species) on and between critical surfaces. Pellicles can typically withstand up to 100 Pa overpressure, thus a significant flow can be provided with a pressure difference across the pellicle around 10-50 Pa (allowing a factor of 2 margin for safety). In some embodiments, hydrogen may even be provided between the reticle and the pellicle at pressures of the order of 10-100 Pa.

As with the apparatus 200 shown in Figure 2, optionally, the apparatus 300 of Figure 3 may further comprise an enclosure 260 and associated pumps 262, substantially as described above with reference to Figure 2. It will be appreciated that in addition to supplying the one or more nozzles with hydrogen, the hydrogen supply 250 may be operable to provide a flow of hydrogen to a main part of such an enclosure 260. Alternatively, the apparatus 300 may have no enclosure but rather may be provided within a controlled environment within another apparatus. For example, the apparatus 300 may be provided within a part of a lithographic apparatus of the type shown in Figure 1.

The electron source 310 may comprise an electron gun. The electron gun may be a high-pressure electron gun. The electron gun may be operable to work in a working environment having a pressure of the order of 1-100 Pa. The electron source 310 is operable to direct electrons 311 so as to be incident on the pellicle of a reticle and pellicle assembly when supported by the support 220.

In this embodiment, the apparatus 300 further comprises electron optics 312 arranged to receive an electron beam 311 from the electron source and to distribute the electron beam over a surface of the pellicle membrane 240 of a reticle and pellicle assembly when supported by the support 220. The electron optics 312 receives the electron beam 311 from the electron source and outputs a spatially expanded electron beam 313.

The electron optics 312 may comprise electrostatic focusing optics. The electron optics 312 may be operable to distribute the electron beam substantially homogenously over a surface of the pellicle membrane 240 of a reticle and pellicle assembly when supported by the support 220. That is, the electron optics 312 may be arranged to provide a uniform irradiation of the full area of a reticle and pellicle assembly.

The electron source 310 of the apparatus 300 shown in Figure 3 is operable to direct electrons 313 so as to be incident on a pellicle of a reticle and pellicle assembly when supported by the support 220. At least a portion of such incident electrons will propagate through the pellicle to the reticle. The electrons can interact with the hydrogen 361 flow from the hydrogen source 250 to create active species, such as $H^*$, $H^+$, $H_2^+$, $H_3^+$, which can reduce (partially) oxidized surfaces, such as reticle front side, and/or promote adsorbed oxygen desorption.

The apparatus 300 is further provided with an electron sink, as now discussed.

The apparatus 300 further comprises an electromagnetic radiation source 370 operable to direct electromagnetic radiation at the pellicle. For example, such an electromagnetic radiation source may comprise a laser, for example an ultraviolet (UV) or deep ultraviolet (DUV) laser. Such an electromagnetic radiation source is operable to provide a photocurrent to the pellicle to compensate for the charging by the electron source (for example by releasing electrons via the photoelectric effect).

In addition, or alternatively, an electron sink may be provided via electrical contact with a grounded support (as described above with reference to Figure 2).

Some features and parameters that may apply to either the apparatus 200 shown in Figure 2 or the apparatus 300 shown in Figure 3 are not discussed.

Note that the electrons produced by the electron source 210, 310 do not need to be mono-energetic in order to provide a cleaning effect and remove oxide layers. Furthermore, any primary electrons from the electron source 210, 310 may give rise to electromagnetic showers when propagating through matter, giving rise to secondary electrons and Bremsstrahlung radiation. Such secondary electrons and Bremsstrahlung radiation will also, in general, provide a cleaning effect and remove oxide layers.

In some embodiments, the hydrogen supply 250 is operable to supply hydrogen at a pressure in the range 50 to 100 Pa. In particular, in the apparatus 300 shown in Figure 3, the hydrogen supply 250 may be operable to direct hydrogen between the reticle and the pellicle of the reticle and pellicle assembly when supported by the support at a pressure in the range 50 to 100 Pa.

With such arrangements, the hydrogen pressure between the pellicle and reticle (and, optionally above a front surface of the pellicle) may be boosted from a typical value of 5-10 Pa within an EUV lithographic apparatus. Advantageously, this can increase generation of active species under the irradiation from the electron source and/or DUV or VUV radiation that may be emitted as Bremsstrahlung radiation.

In some embodiments, the apparatus 200, 300 may further comprise a thermal conditioning unit operable to control a temperature of a reticle and pellicle assembly supported by the support.

For example, such a thermal conditioning unit may comprise a heater operable to increase a temperature of a reticle and pellicle assembly supported by the support. Some heat will be provided to the reticle and pellicle assembly by the electron source. The additional heat provided by a heater may promote water outgassing to reduce residence time of water on relevant surfaces. It is expected that the residence time may be reduced by a factor of 2-10 for every 10 °C increase in temperature of the reticle and pellicle assembly.

The heater may, for example, comprise a radiation source operable to irradiate the pellicle and/or reticle. For example, the radiation source 370 of the embodiment shown in Figure 3 may be considered to provide such a heater. Additionally or alternatively, heat may be provided in any other way (for example via thermal contact with rear side 231 of the reticle substrate 230.

In some embodiments, the thermal conditioning unit may comprise a cooling system operable to reduce a temperature of a reticle and pellicle assembly supported by the support 220. It will be appreciated that in the absence of any such cooling, the process of cleaning a reticle and pellicle assembly using the apparatus 200, 300 described above may increase the temperature of the reticle and pellicle assembly. For example, in use, the electron source 210, 310 may provide a heat load to the assembly of the order of 10-100 W. However, it may be important for the reticle and pellicle assembly to be at substantially the same temperature as a reticle stage MT before it can be clamped the reticle stage and used as part of a lithographic process. The provision of a cooling system may reduce the amount of time taken following the cleaning process before the reticle and pellicle assembly can be safely clamped onto a reticle stage MT.

In some embodiments, when a reticle and membrane assembly is supported by the support 220, the support 220 may provide an electrical connection between the reticle front surface and the pellicle membrane. Advantageously, this can reduce any biasing voltage across the reticle and pellicle (which could exert electrostatic pressure on the pellicle).

In some embodiments, the electron source 210, 310 is arranged to direct electrons so as to be incident on a pellicle of a reticle and pellicle assembly when supported by the support 220 such that a portion of said electrons which propagates through the pellicle has an energy of less than 500 eV. In some embodiments, the electron source 210, 310 may be arranged such that the portion of electrons which propagates through the pellicle has an energy of less than 100 eV. This may ensure that the pellicle membrane 240 does not rupture due to electrostatic attraction to the reticle (pellicles are known to break, if there is a voltage drop to reticle of the order of 200 V).

In some embodiments, the electron source 210, 310 is arranged to direct electrons so as to be incident on a pellicle of a reticle and pellicle assembly when supported by the support 220 such that a portion of said electrons which propagates through the pellicle membrane 240 achieves a secondary electron yield of greater than 1 at the reticle. This may be achieved is a beam of electrons from the electron source, once attenuated by the pellicle has an energy of approximately 100-300 eV. Advantageously, with such an arrangement any biasing voltage across the reticle and the pellicle may be minimized whilst only the pellicle is grounded.

In some embodiments, the energy of the electrons impinging on the reticle may be selected such that they are absorbed in the first few layers of the multilayer mirror structures on the reticle. It may be undesirable for the electrons to propagate into the reticle substrate 230 (which may be formed from an ultra low expansion material).

In some embodiments, the electrons impinging on the reticle and pellicle assembly may have a current of the order of 10 mA.

As already discussed above, in some embodiments, the apparatus 200, 300 may be provided within a lithographic apparatus LA of the type shown in Figure 1.

Such a lithographic apparatus is particularly advantageous since it allows reticle and pellicle assemblies to be processed using the apparatus 200, 300 described above whilst in the controlled environment of the lithographic apparatus LA. This avoids the need to remove the reticle and pellicle assembly from the lithographic apparatus LA, process it to reduce any partial oxidization, and then replace the reticle and pellicle assembly back in the lithographic apparatus LA. Each time a reticle and pellicle assembly is exposed to air or any environment with a significant content of oxygen and/or water it may be desirable to reduce any partial oxidization to avoid reflectivity variations.

In general, a lithographic apparatus is provided with a plurality of reticle and pellicle assemblies. These are stored in a reticle library when not being used as part of a lithographic exposure. When desired or required, a reticle and pellicle assembly can be retrieved from the reticle library using a reticle exchange device arm and moved from the reticle library to the support structure MT.

In some embodiments, one of the above-described apparatus 200, 300 (or a variant thereof) may be provided in a reticle library of a lithographic apparatus or on a reticle exchange device arm of a lithographic apparatus.

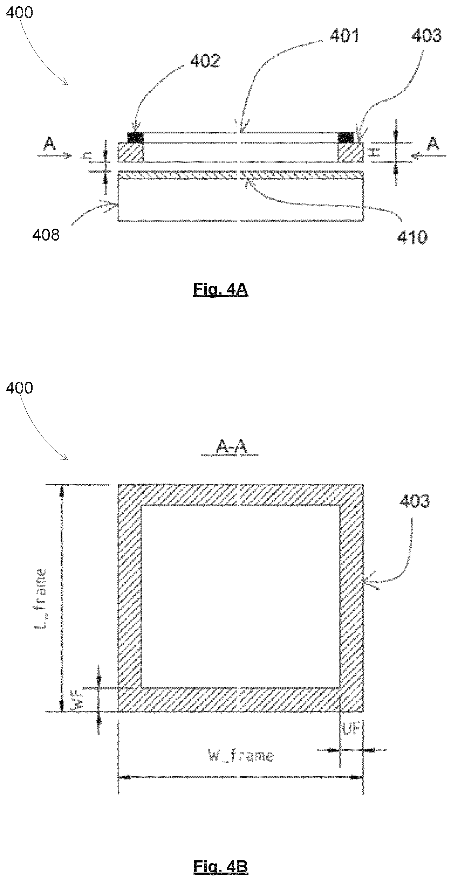

Some embodiments of the invention relate to a new reticle and pellicle assembly, as now discussed with reference to Figures 4A, 4B, 5A and 5B.

Figures 4A and 4B show two mutually orthogonal cross sectional views of a known reticle and pellicle assembly 400. As shown in Figure 4A, the known reticle and pellicle assembly 400 is generally of the form of the reticle and pellicle assembly shown in Figure 2. The reticle and pellicle assembly 400 comprises a pellicle comprising a pellicle membrane 401 and a pellicle border 402. The pellicle border is attached (for example using an adhesive) to a pellicle frame 403 so as to form a pellicle assembly.

The reticle and pellicle assembly 400 further comprises a reticle comprising a reticle substrate 408 and a reticle front surface structure 410.

The pellicle frame 403 is connected to the reticle front surface structure 410 of the reticle to facilitate connection of the pellicle to the reticle. However, this connection is not shown in the cross section of Figure 4A. It will be appreciated that the pellicle frame 403 may comprise attachment mechanisms and that intermediate fixing members (known as studs) may be affixed to the reticle front surface structure 410 of the reticle. The intermediate fixing members (studs) on the reticle may engage (for example releasably engage) with the attachment members of the pellicle frame 403 to provide connections.

Figure 4B shows a cross section through the pellicle frame 403 in the plane A-A (see Figure 4A).

The connections are such that there is a gap h ~ 0.1 mm is provided between the pellicle frame 403 and the reticle front surface structure 410 of the reticle. A thickness H of the pellicle frame in the plane of Figure 4A is typically significantly larger than the gap h (i.e. typically h<<H). For example, the thickness H of the pellicle frame in the plane of Figure 4A may be of the order of 1-5 mm.

With such an arrangement, the gas conductance in the molecular regime (which is relevant for water vapor, a product of reduction or for oxygen, a product of desorption) between the volume between the pellicle and the reticle and the surrounding environment is limited by the narrow slit between the pellicle frame and the reticle. This slit or flowpath has a height ~ h; a length which scales with a thickness of the frame (in the plane of Figure 4B) such that length ~ (WF, UF); and a width of the perimeter of the pellicle frame 403, i.e. length ~ (L_frame + W_frame)*2. Typically, the widths of the frame in the plane of Figure 4B are ~5-10 mm. Therefore, the fluid conductance in the molecular regime between the volume between the pellicle and the reticle and the surrounding environment scales as $C \cong h^3 * L/W$.

Figures 5A and 5B show two mutually orthogonal cross sectional views of a new reticle and pellicle assembly 500 according to an embodiment of the invention. The reticle and pellicle assembly 500 is generally of the form of the reticle and pellicle assembly shown in Figures 4A and 4B except that it has a modified pellicle frame 503.

As can be seen from Figure 5B, the pellicle frame 503 comprises four wall portions 505 arranged to provide a generally rectangular body surrounding a generally rectangular aperture 506 (above which the pellicle membrane 401 extends). Two opposed wall portions 505 are provided with three channels 504 from an exterior surface 507 of the wall portion 505 to an interior surface 509 of the wall portion 505 adjacent the generally rectangular aperture 506.

The channels 504 are non-linear. In particular, each channel has a first portion extending into the wall portion 505 from the exterior surface 507 of the wall portion 505 and a second portion extending into the wall portion 505 from the exterior surface 507 of the wall portion 505. The first and second portions are connected by a third, central portion which is generally perpendicular to the first and second portions (i.e. the third portion is generally parallel to the wall portion 505).

The new reticle and pellicle assembly 500 is advantageous, as now discussed.

When the pellicle frame 503 is engaged with the reticle, the wall portions 505 of the pellicle frame 503 are adjacent a non-image formation portion of the reticle. In addition to supporting the pellicle, the pellicle frame generally surrounds a volume defined between the reticle and the pellicle (see Figure 5A). This is advantageous since it can limit the amount of particulate debris that can enter the volume defined between the reticle and the pellicle, preventing debris from impinging on the reticle (which could form errors in an image of the reticle formed on a substrate). However, when the reticle and pellicle assembly 500 is being processed (for example, using the apparatus 200, 300 described above with reference to Figures 2 and 3) to reduce any oxidization on surfaces of the reticle and pellicle, the presence of a pellicle frame 403 of the type shown in Figures 4A and 4B means that water and/or oxygen released from the reticle front side and pellicle back side cannot easily exit the volume between the pellicle and the reticle. Furthermore, any oxygen and water trapped between the pellicle membrane and the reticle front side can be re-captured (re-oxidizing the reticle and pellicle or getting adsorbed), extending the time of transmission recovery.

However, the provision of the non-linear channels 504 from an exterior surface 507 of the wall portion 505 to an interior surface 509 of the wall portion 505 adjacent the generally rectangular aperture 506 can provide better fluid communication between the volume defined between the reticle and the pellicle and the surrounding environment. For example, the channels 504 can increase a fluid conductance between the volume defined between the reticle and the pellicle and the surrounding environment for a molecular flow of water vapor. Since they are non-linear, the channels 504 can prevent ballistic particle transport through the channels 504 (for example during pump down and vent of the reticle and pellicle assembly 500).

The channels 504 may accelerate gas exchange between the volume defined between the reticle and the pellicle and the surrounding environment and therefore speed up water removal from the annealed pelliclized reticle either during processing using the apparatus 200, 300 described above with reference to Figures 2 and 3 or in use during EUV exposure within a lithographic exposure process.

In general, the channels 504 may have any suitable shape and, in general, defines a convoluted or labyrinth flow path from the exterior surface 507 of the wall portion 505 to the interior surface 509 of the wall portion 505 adjacent the generally rectangular aperture 506.

In this embodiment, three channels 504 are provided on each of two opposed wall portions 505 from an exterior surface 507 of the wall portions 505 to an interior surface 509 of the wall portions 505. Advantageously, such an arrangement provides a suitable arrangement to provide a flow of hydrogen between the pellicle and the reticle. The channels 504 in one wall portion may form an inlet for such a flow and the channels 504 in the opposed wall portion may form an outlet for such a flow. This allows the flow to be substantially in one direction and may, for example, be referred to as a cross-flow. Advantageously, this can refresh gas in the volume between the reticle and the pellicle and therefore accelerate water removal and reduce residence time for water molecules (generated during reduction by active species) on and between critical surfaces. Pellicles can typically withstand up to 100 Pa overpressure, thus a significant flow can be provided with a pressure difference across the pellicle around 10-50 Pa (allowing a factor of 2 margin for safety). In some embodiments, hydrogen may even be provided between the reticle and the pellicle at pressures of the order of 10-100 Pa.

The reticle and pellicle assembly 500 shown in Figures 5A and 5B may be particularly suitable for use in the apparatus 300 shown in Figure 3.

As with the known reticle and pellicle assembly 400 shown in Figures 4A and 4B, a gap h between the pellicle frame 503 and the reticle front surface structure 410 is of the order of 0.1 mm whereas the a thickness H of the pellicle frame 503 in the plane of Figure 5A is typically significantly larger than the gap h (i.e. typically h<<H). For example, the thickness H of the pellicle frame 503 in the plane of Figure 5A may be of the order of 1-5 mm.

As with the known reticle and pellicle assembly 400 shown in Figures 4A and 4B, there is a fluid conductance between the volume between the reticle and the pellicle and the surrounding environment via gap h. However, the channels 504 provided on each of two opposed wall portions 505 provide additional fluid conductance, as now discussed.

The extra gas conductance in the molecular regime (which is relevant for water vapor, which is a product of reduction or for oxygen, which is a product of desorption) scales as $C_{extra} \cong N * (Q^3 * P/Z)$, where N is number of channels 504, $P$ is a width of the third portion of the central portion of the channels 504 (which is generally parallel to the wall portion 505) and Z is a length of the third portion of the central portion of the channels 504 (which is generally parallel to the wall portion 505), and Q is the height of the third portion of the central portion of the channels 504 (which is generally parallel to the wall portion 505). This assumes that the conductance of the input and output (R_in, R_out) apertures (i.e. the first and second portions of the channels 504) are significantly larger than that of the central, third portion and therefore not process limiting. By appropriate selection of the parameters of the channels 504, it is possible to arrange that $C_{extra} \sim 100 * C$, i.e. the additional conductance provided by the channels is 100 times greater than the conductance provided by the gap h.

It is desirable to preserve a stiffness of the pellicle frame 503. Therefore, preferably the height of the third portion of the central portion of the channels 504 is of the order of 0.2-0.8 times the height of the pellicle frame 503 (i.e. $Q \sim 0.2\text{-}0.8 * H$).

The geometry of the new pellicle frame 503 may be more difficult to clean than existing pellicle frames. Therefore, it may be desirable for the new pellicle frame 503 to be electropolished after manufacture to remove any sharp edges.

In some embodiments, the at least one channel increases a fluid conductance between a volume defined between the reticle and the pellicle and a surrounding environment by factor of at least 10.

In some embodiments, a conducting coating is provided on at least on the part of the pellicle. Said conducting coating may be similar to the a conducting coating 242 provided on the pellicle shown in Figure 2.

Some embodiments relate to methods for processing a reticle and pellicle assembly for a lithographic apparatus. Generally, such methods may comprise: providing a reticle and pellicle assembly; supporting the reticle and pellicle assembly; supplying hydrogen in the vicinity of the reticle and pellicle assembly; and directing electrons so as to be incident on the pellicle of the reticle and pellicle assembly such that at least a portion of the incident electrons propagate through the pellicle towards the reticle of the reticle and pellicle assembly.

Such methods allow a reticle and pellicle assembly to be reduced, since the at least a portion of the incident electrons that propagate through the pellicle to the reticle can interact with the hydrogen supplied in the vicinity of the reticle and pellicle assembly to create active species, such as $H^*$, $H^+$, $H_2^+$, $H_3^+$. These active species can reduce (partially) oxidized surfaces, such as reticle front side, and/or promote adsorbed oxygen desorption.

It will be appreciated that these methods may be carried out using an apparatus 200, 300 as described above. These methods may therefore include any of the above-described functionality of the apparatus 200, 300 as described above.

It will be appreciated that these methods may be carried out a reticle and pellicle assembly 500 as described above. These methods may therefore include any of the above-described functionality of the reticle and pellicle assembly 500 as described above.

As discussed above, within a lithographic apparatus a supply of hydrogen gas may be provided in the vicinity of a reticle and pellicle assembly. This hydrogen gas can have a cleaning effect on the surfaces of the reticle and pellicle assembly. For example, the flow of hydrogen may reduce an amount of debris that is incident on the surfaces of the object. Furthermore, during an exposure of a substrate within the lithographic apparatus, in the presence of the EUV radiation, the hydrogen gas from the hydrogen supply may form a plasma in the vicinity of the reticle and pellicle assembly. This plasma will have a cleaning effect on the surfaces of the object, reacting with oxygen on the surfaces of the object (so as to reduce said surfaces) and reacting with debris on said surfaces so as to aid the removal of such debris.

Pellicles for use in an EUV lithographic apparatus are typically formed from silicon and carbon compounds. These materials suffer from Hydrogen Induced Outgassing (HIO). Through a few reaction steps, hydrogen removes the (native) oxide shell of such pellicles, and then the silicon or carbon core. For silicon-based pellicles, this etching of the silicon core by the hydrogen plasma forms silane $SiH_4$ whereas for carbon-based pellicles this etching of the carbon core by the hydrogen plasma forms methane compounds. To prevent or reduce this plasma etching, it may be desirable to develop etch resistant capping materials that can protect the pellicle. However, it is not trivial to find such capping materials that are sufficiently impermeable to hydrogen.

Some embodiments relate to apparatus and associated methods that use magnetic fields to reduce a flux of charged particles from the plasma that is incident on the surfaces of the pellicle assembly. Although described in the context of protecting the pellicle from hydrogen plasma etching, it will be appreciated that these embodiments may alternatively be used to protect a surface of any object from such a plasma environment. In particular, within a lithographic apparatus, these embodiments may be used to protect surfaces of other objects such as sensors, mirrors, walls or other components.

As now discussed, it is estimated that with typical conditions within an EUV lithographic apparatus, a hydrogen plasma can be affected by a magnetic field of reasonable strength , for example with a magnetic field strength of the order of 0.2 T.

First, we estimate a typical density of particles in the vicinity of the pellicle. Assuming a typical hydrogen gas density of the order of 5P and a temperature of 273 K, the number of molecules per unit volume can be estimated using the ideal gas law:

$$\frac{n}{V} = \frac{P}{kT} = \frac{5}{1.38 * 10^{-23} * 273} = 1.3 * 10^{21} \frac{molecules}{m^3}$$

where $n$ is the number of molecules, $V$ is the volume, $P$ is the pressure, $k$ is the Boltzmann conastant and $T$ is the temperature.

The plasma density is $\sim 10^{15}$ ions/m$^{-3}$ since only one in $10^6$ particles is ionized. Since the number of ions is negligible in comparison to neutral molecules, we consider collisions of ions with neutral species.

Next we estimate the mean free path (mfp) for hydrogen ions and electrons. We estimate the mean free path for hydrogen ions using the kinetic theory of gases and assuming that the collisions are mostly with neutral hydrogen molecules. We take the molecule diameter $d$ for the H$_2$ molecule to be 0.3 nm, which gives the following *mfp* for atom-molecule collisions:

$$mfp_{H_3^+} = \frac{RT}{\sqrt{2}\pi d^2 N_A P} = 1.9 * 10^{-3} \, m$$

where $R$ is the universal gas constant and $N_A$ is the Avogadro constant.

For collisions between electrons and hydrogen molecules, we assume a collision cross section $\sigma$ of $10^{-20}$ m$^2$. This allows us to estimate the mean free path for electrons as:

$$mfp_{e^-} = \frac{1}{\sigma} * \frac{V}{n} = \frac{1}{10^{-20}} * \frac{1}{1.3 * 10^{21}} = 8 * 10^{-1} \, m$$

Finally, for both hydrogen ions and electrons, we calculate Larmor radius and compare this to the mean free path. In a magnetic field, the Larmor radius $R$ for a charged particle is given by:

$$R = \frac{mv}{qB}$$

where $m$ is the mass of the charged particle, $v$ is the velocity of the particle, $q$ is the electric charge of the particle and $B$ is the magnetic field strength (in Tesla). The velocity of the particles can be estimated from kinetic gas theory as

$$v = \sqrt{\frac{2k_B T}{m}}$$

where the temperature $T$ is 300 K and 11600 K (1 eV) for ions and electrons respectively.

From these, for a field strength of 0.2 T, the Larmor radius for hydrogen ions is estimated to be $R_{H3+} = 2.0*10^{-4}$ m; and the Larmor radius for electrons is estimated to be $R_{e-} = 1.7*10^{-5}$ m.

For ions the Lamor radius is 1 order of magnitude smaller than the mean free path. For electrons the Lamor radius is 4 orders of magnitude smaller than the mean free path. This means that in a 0.2 T magnetic field ions will typically complete a few circular Larmor orbits around a magnetic field line before colliding with a neutral gas species. Furthermore, electrons will typically make many thousands of orbits before colliding with a neutral gas species, which means that they are significantly affected by the magnetic field (and would be even if the magnetic field strength were lowered by one or two orders of magnitude). Furthermore, the main driving force for ion movement is through ambipolar diffusion. To retain charge neutrality in the volume, the slow (positively charged) ions are always following the movement of the faster negatively charged electrons, even if they scatter from neutral species while doing so. This means that effective control over the electrons also yields control over the ions.

We may therefore conclude that for a field strength of 0.2T, the hydrogen plasma is magnetized and the hydrogen plasma is significantly affected by the magnetic field. However, for a solution to be effective, it is desirable for the magnetic field to be arranged so as to stop a significant fraction of the ion flux from reaching the pellicle, while preventing excessive plasma build-up in the lithographic apparatus due to the added confinement.

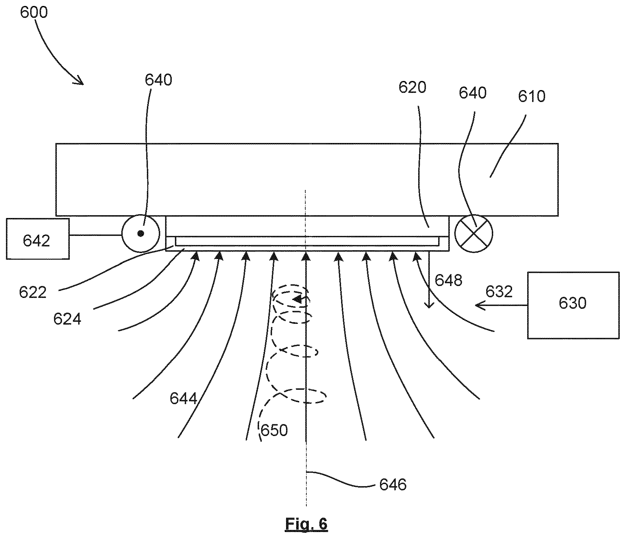

Examples of embodiments that use magnetic fields to reduce a flux of charged particles from the plasma that is incident on the surfaces of the pellicle assembly are now discussed with reference to Figures 6 to 8.

Figure 6 is a schematic illustration of an apparatus 600 according to an embodiment. The apparatus 600 shown in Figure 6 comprises a support 610 for supporting an object. In this example, the support 610 is reticle stage and may, for example, be the support structure MT shown in Figure 1. The object is a reticle and pellicle assembly and may, for example, be the reticle assembly 15 shown in Figure 1. In particular, the object comprises a reticle or patterning device 620 and a pellicle, in turn the pellicle comprises a pellicle frame 622 and a pellicle membrane 624.

The apparatus 600 shown in Figure 6 further comprises a hydrogen supply 630 operable to supply hydrogen 632 in the vicinity of the pellicle membrane 624. The hydrogen gas may be supplied, for example, at a pressure of the order of 5 Pa.

The apparatus 600 shown in Figure 6 further comprises a coil 640 and a power supply 642 operable to generate a current in the coil 640. A plane of the coil is generally parallel to a plane of the support 610, the reticle 620 and the pellicle membrane 624. The coil 640 generally surrounds the pellicle membrane 624.

With such an arrangement, when the power supply 642 supplies current to the coil 640, a magnetic field 644 (illustrated by solid lines with arrows) is generated in the vicinity of the pellicle membrane 624 when supported by the support 610. The power supply 642 supplies current to the coil 640 may be considered to be a magnetic field generator operable to generate a magnetic field in the vicinity of the pellicle membrane 624 when supported by the support 610.

The magnetic field 644 is symmetric about a line or axis 646 that is generally perpendicular to and passes through the center of the coil 640. The magnetic field strength of the magnetic field 644 decreases in a direction generally perpendicular to and away from a surface of the pellicle membrane 624 when supported by the support 610 (i.e. in the direction indicated by arrow 648).

The power supply 642 and the coil 640 may be considered to be a dipole magnet arranged such that its dipole axis 646 is perpendicular to the surface of the pellicle membrane 624 when supported by the support 610. With such an arrangement, the magnetic field lines 644 have a component that is parallel to the surface of the pellicle membrane 624 when supported by the support 610.

Advantageously, by creating a magnetic field 644 which decreases in a direction 648 generally perpendicular to and away from a surface of the pellicle membrane 624 when supported by the support 610, as a particle moves towards the surface of the membrane 624 it will experience an increased magnetic field. In turn, the velocity of the particle perpendicular to the magnetic field 644 increases and the velocity of the particle parallel to the magnetic field 644 decreases. An example trajectory 650 of a charged particle in the magnetic field 644 is also shown in Figure 6 (dashed line with an arrow). For at least some fraction of charged particles, the velocity of the particle parallel to the magnetic field 644 will fall to zero and the particle will reverse direction. Such an arrangement is known as a magnetic mirror and is discussed further below.

When a charged particle (ion or electron) moves at an angle to the magnetic field lines 644, it will start to rotate. This is known as Larmor precession. When the charged particle gets closer to the coil 640, due to the higher magnetic field 644, more energy is converted from forward momentum into rotation. This constitutes an effective force away from the coil 640, which slows and eventually reverses the direction of the particle (in a direction parallel to the axis 646 of the coil 640). This is similar to one half of a magnetic mirror machine (also known as a magnetic bottle) that is used for plasma confinement in some plasma fusion reactors. In such a magnetic bottle, two coils are used that each act as magnetic mirrors and the plasma is trapped between these two magnetic mirrors. In contrast, for the purpose of shielding a reticle or pellicle surface, it is proposed that only one such magnetic mirror is used.

For the magnetic mirror formed by the coil 640, we can define the so-called loss cone with an opening angle $\theta$. Any particles within the loss cone will pass through the coil 640 whereas any particles outside of the loss cone will be reflected by the magnetic field 644 as described above. Reflected particles satisfy the following criterion:

$$\sin(\theta) = \frac{v_{perp}}{v_{tot}} > \frac{1}{\sqrt{\frac{B_{max}}{B_{min}}}},$$

where $v_{perp}$ is the component of the initial velocity of the particle perpendicular to the magnetic field, $v_{tot}$ is the total velocity of the particle, $B_{max}$ is the magnetic field strength at the coil 640 and $B_{min}$ is the magnetic field strength at a position where the particle first sees the field. It is useful to define the mirror ratio $R_m$ as:

$$R_m = \frac{1}{\sin^2(\theta)} = \frac{B_{max}}{B_{min}}.$$

Given the initial random nature of the velocity of charged particles from the plasma that are within the magnetic field, it is desirable for the mirror ratio to be as high as possible in order to reflect as many particles as possible.

Since a single coil 640 is used, the field at the location where the ion is created by the EUV radiation beam is the most useful metric for $B_{min}$, while $B_{max}$ is given by the field at the coil 640. Typically, ions may be created by the EUV radiation at a range of around ~1-10 cm from the pellicle membrane 624 and the coil 640.

For a coil with radius $a$, the field at an axial distance $z$ away from the center scales as $B_z \sim (a^2 + z^2)^{-\frac{3}{2}}$.

For particle that is created at a distance a=10cm from the pellicle membrane 624, $B_{min}$ is a factor of 3 smaller than $B_{max}$ $\left(\frac{(0.1^2+0)^{-\frac{3}{2}}}{(0.1^2+0.1^2)^{-\frac{3}{2}}} \sim 3\right)$. The fraction of particles that this would stop is 1 minus the fraction of particles that are within the loss cone. The fraction of particles within the loss cone is given by $\theta$ divides by $\frac{\pi}{2}$. Therefore, the percentage of particles mirrored is given by:

$$\left[1 - \frac{\text{asin}\left(\sqrt{\frac{B_{min}}{B_{max}}}\right)}{\frac{\pi}{2}}\right] * 100\% = 61\%$$

For particle that is created at a distance a=10cm from the pellicle membrane 624, $B_{min}$ is a factor of 1.05 smaller than $B_{max}$, which results in only 14% of the particle flux being mirrored.

The apparatus 600 shown in Figure 6 advantageous, since the magnetic field 644 generated by the coil 640 and power supply 642 is operable to act on the charged particles within the plasma via the Lorentz force. In so doing, the magnetic field 644 can direct these charged particles (and in particular the hydrogen ions) away from the surface of the pellicle membrane 624. Advantageously, this can reduce the plasma etching rate and so extend the lifetime of the pellicle.

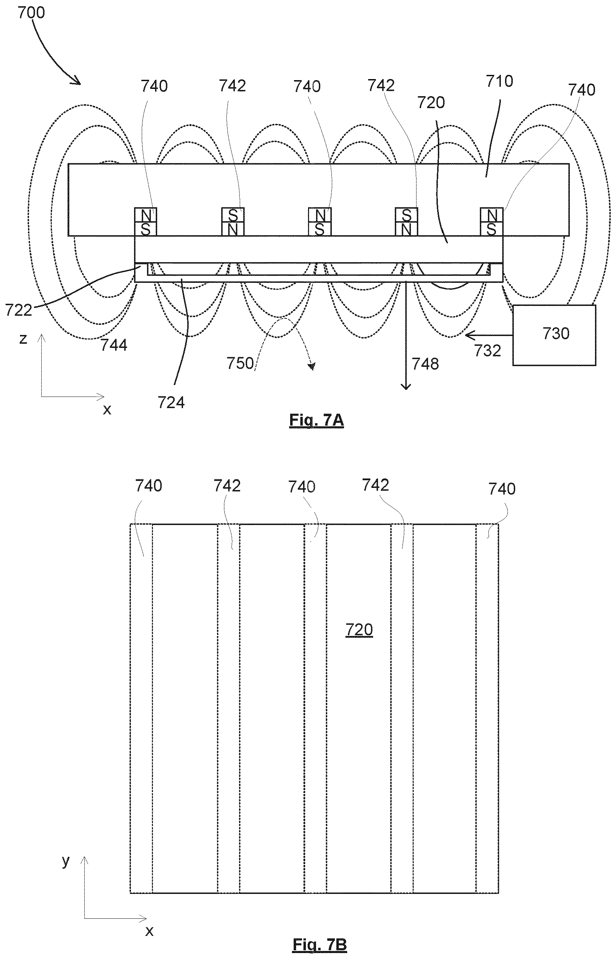

Figure 7A is a schematic illustration of an apparatus 700 according to an embodiment. The apparatus 700 shown in Figure 7 comprises a support 710 for supporting an object. In this example, the support 710 is reticle stage and may, for example, be the support structure MT shown in Figure 1. The object is a reticle and pellicle assembly and may, for example, be the reticle assembly 15 shown in Figure 1. In particular, the object comprises a reticle or patterning device 720 and a pellicle. In turn, the pellicle comprises a pellicle frame 722 and a pellicle membrane 724.

The apparatus 700 shown in Figure 7 further comprises a hydrogen supply 730 operable to supply hydrogen 732 in the vicinity of the pellicle membrane 724. The hydrogen gas may be supplied, for example, at a pressure of the order of 5 Pa.

The apparatus 700 shown in Figure 7 further comprises a plurality of magnets 740, 742 distributed over a plane of the support 720. The magnets 740, 742 may, for example, be embedded within a body of the support 720. Each of the magnets 740, 742 has a dipole orientated generally perpendicular to a plane of the support 720, a plane of the reticle 722 and a plane of the pellicle membrane 724.

The plurality of magnets 740, 742 may be considered to be a magnetic field generator operable to generate a magnetic field 744 (shown by dotted lines) in the vicinity of the pellicle membrane 724 when supported by the support 710. The magnetic field strength of the magnetic field 744 decreases in a direction generally perpendicular to and away from a surface of the pellicle membrane 724 when supported by the support 710 (i.e. in the direction indicated by arrow 748).

The magnets 740, 742 may comprise permanent magnets of electromagnets.

The magnets 740, 742 are arranged such that the dipole moments of each pair of adjacent magnets 740, 742 of the plurality of magnets 740, 742 distributed over a plane of the support 720 are anti-parallel. In order to achieve this, the plurality of magnets 740, 742 comprise a first set of magnets 740 having a first polarity and a second set of magnets 742 having a second, opposite polarity. The first and second set of magnets 740, 742 are arranged alternately such that each magnet from any of the first and second sets 740, 742 is adjacent to magnets from the other set only.

With such an arrangement, the magnetic field lines from each magnet 740, 742 will extend to or from the adjacent magnets 740, 742 (of opposite polarity). Furthermore, the magnetic field strength will decrease in a direction generally perpendicular to and away from a surface of the pellicle membrane 724 when supported by the support 720 (i.e. in the direction indicated by arrow 648). With such an arrangement, the magnetic field lines 744 have a component that is parallel to the surface of the pellicle membrane 724 when supported by the support 710.

Advantageously, by creating a magnetic field 744 which decreases in a direction 748 generally perpendicular to and away from a surface of the pellicle membrane 724 when supported by the support 710, as a particle moves towards the surface of the membrane 724 it will experience an increased magnetic field. In turn, the velocity of the particle perpendicular to the magnetic field 744 increases and the velocity of the particle parallel to the magnetic field 744 decreases. An example trajectory 750 of a charged particle in the magnetic field 744 is also shown in Figure 7 (dashed line with an arrow). For at least some fraction of charged particles, the velocity of the particle parallel to the magnetic field 744 will fall to zero and the particle will reverse direction.

The ensemble magnetic field 744 of the plurality of magnets 740, 742 comprises alternating region of high magnetic field close to the pellicle membrane and sudden transitions (cusps) to a very small magnetic field. In particular, there is a magnetic field cusp in the magnetic field 744 adjacent to each of the magnets 740, 742. Such an arrangement may be known as a magnetic picket fence. This type of arrangement is used in plasma chambers for materials modification and as ion thrusters for satellites. It is thought that the successful application of this concept may generally be more efficient than a magnetic mirror.

Figure 7A is a cross-sectional view in a plane perpendicular to the plane of the pellicle membrane 724. Figure 7B is a plan view showing the positions of the magnets 740, 742 relative to the plane of the reticle 720. Figures 7A and 7B are consistently labelled with a set of right-handed Cartesian axes. In this embodiment, each of the magnets 740, 742 is elongate in a direction perpendicular to its dipole moment (the y-direction in Figures 7A and 7B).

With such an arrangement, each magnet 740, 742 produces a magnetic field which is be locally symmetric about a plane that is generally parallel to the dipole moment of that magnet 740, 742 (these symmetry planes are parallel to the z-y plane in Figures 7A and 7B). There is a line cusp adjacent to each of the plurality of magnets 740, 742. The magnetic field strength decreases in the direction 748 generally perpendicular to and away from a surface of the pellicle membrane 724 when supported by the support 710.

Although in this embodiment, the magnets 740, 742 are elongate so as to produce a plurality of line cusps, in alternative embodiments, the magnets may be arranged in various different shapes, aligned with their dipole moments perpendicular to the surface of the pellicle membrane 724. For example, a two dimensional array of magnets may be provided (for example in a square or hexagonal array) with adjacent pairs of magnets having opposite polarity. Such an arrangement may generate a magnetic field that has a shape somewhat similar to the bottom of an egg box.

For such an arrangement the loss width w may be usually as the width of a Gaussian beam of ion flux which passes to the pellicle at the point of lowest magnetic field. This width w will decrease for higher magnetic fields, and should scale with the hybrid gyroradius:

$$w \sim \sqrt{R_{H_3^+} R_{e^-}} \sim 10^{-4} \; m.$$

This loss width is significantly smaller (a few %) than the typical pole-to-pole separation (which may be, for example, at least 1 cm). Therefore, with apparatus 700 shown in Figure 7 it is expected that a relatively small fraction of particles will be incident on the pellicle membrane 724.

The apparatus 700 shown in Figure 7 advantageous, since the magnetic field 744 generated by the magnets 740, 742 is operable to act on the charged particles within the plasma via the Lorentz force. In so doing, the magnetic field 744 can direct these charged particles (and in particular the hydrogen ions) away from the surface of the pellicle membrane 724. Advantageously, this can reduce the plasma etching rate and so extend the lifetime of the pellicle.

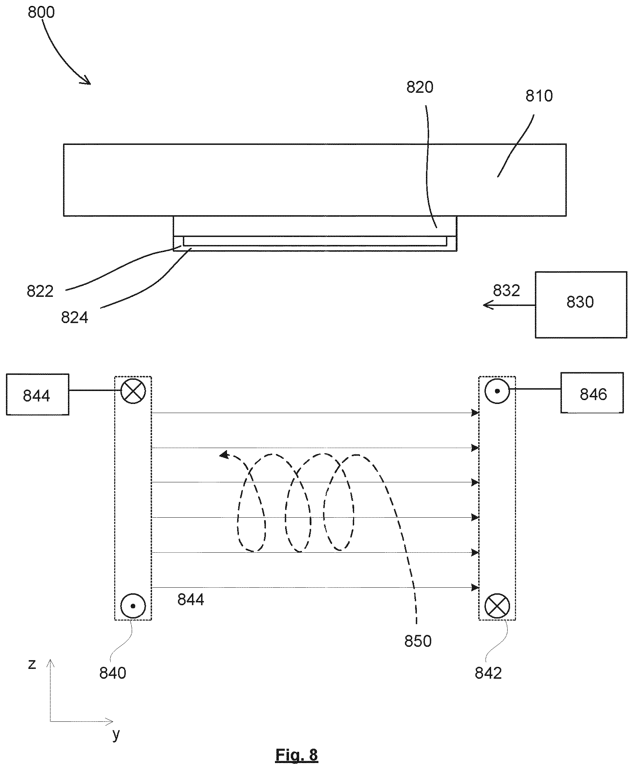

Figure 8 is a schematic illustration of an apparatus 800 according to an embodiment. The apparatus 800 shown in Figure 7 comprises a support 810 for supporting an object. In this example, the support 810 is reticle stage and may, for example, be the support structure MT shown in Figure 1. The object is a reticle and pellicle assembly and may, for example, be the reticle assembly 15 shown in Figure 1. In particular, the object comprises a reticle or patterning device 820 and a pellicle. In turn, the pellicle comprises a pellicle frame 822 and a pellicle membrane 824.

The apparatus 800 shown in Figure 8 further comprises a hydrogen supply 830 operable to supply hydrogen 832 in the vicinity of the pellicle membrane 824. The hydrogen gas may be supplied, for example, at a pressure of the order of 5 Pa.

The apparatus 800 shown in Figure 8 further comprises a pair of opposed coils 840, 842 and a pair of associated power supplies 844, 846. A plane of each of the pair of coils 840, 842 is generally perpendicular to the surface of the pellicle membrane 824 when supported by the support. In Figure 8, the plane of the pellicle membrane 824 is parallel to the x-y plane whereas the plane of each of the coils 840, 842 is parallel to the x-z plane.

A first power supply 844 is operable to generate a current in one of the coils 840 and a second power supply 846 is operable to generate a current in the other one of the coils 842. Although in this embodiment, each of the coils 840, 842 is provided with a separate power supply in other embodiments the two coils 849, 842 may share a common power supply.

It will be appreciated that the power supplies 844, 846 are arranged such that the polarities of the dipole magnetic fields generated by the two coils 840, 842 are generally opposed. The two opposed coils 840, 842 may therefore be generally of the form of Helmholtz coils, generating a generally uniform magnetic field 844 between the two coils 840, 842. The pair of coils 840, 842 may be generally circular, square or rectangular.

The pair of coils 840, 842 (and the associated power supplies 844, 846) may be considered to be a magnetic field generator operable to generate a magnetic field 844 (shown by solid lines with arrows) in the vicinity of the pellicle membrane 824 when supported by the support 810. The magnetic field 844 is generally parallel to the surface of the pellicle membrane 824 when supported by the support 810.

With this arrangement, as charged particles propagate through the magnetic field 844 towards the surface of the pellicle membrane 824, they will tend towards a helical path within the magnetic field 844. An example trajectory 850 of a charged particle in the magnetic field 844 is also shown in Figure 8. Advantageously, at least a portion of such particles will be trapped in this helical path within the magnetic field 844 and will not be incident on the surface of the pellicle membrane 824.

The apparatus 800 shown in Figure 8 generates a magnetic field parallel to the plane of the pellicle membrane 824. As derived above, this will strongly affect the motion of electrons, trapping them to move only parallel to the surface of the pellicle membrane 824. Due to ambipolar diffusion, ions will be trapped as well.

As explained above, the apparatus 800 shown in Figure 8 may be provided in the lithographic apparatus LA shown in Figure 1.

The lithographic apparatus LA is provided with four reticle masking blades, which define the extent of the field on the patterning device MA which is illuminated. The illumination system IL is operable to illuminate a region of the patenting device MA when disposed on the support structure MT. This region may be referred to as the slit of the illumination system IL and is at least partially defined by four reticle masking blades, which define a generally rectangular region of the patterning device which can receive radiation. The extent of the generally rectangular region in a first direction, which may be referred to as the x direction, is defined by a pair of x masking blades. The extent of the generally rectangular region in a second direction, which may be referred to as the y direction, is defined by a pair of y masking blades.

Each of the masking blades is disposed close to, but slightly out of the plane of the patterning device on the support structure MT. The x masking blades are disposed in a first plane and the y masking blades are disposed in a second plane.

Each of the masking blades defines one edge of a rectangular field region in the plane of the patterning device MA which can receive radiation. Each blade may be independently movable between a retracted position wherein it is not disposed in the path of the radiation beam and an inserted position wherein it at least partially blocks the radiation beam projected onto the patenting device MA by the illumination system IL. By moving the masking blades into the path of the radiation beam, the radiation beam B can be truncated (in the x and/or y direction) thus limiting the extent of the field region which receives radiation beam B.

The x-direction corresponds to a non-scanning direction of the lithographic apparatus LA and the y-direction corresponds to a scanning direction of the lithographic apparatus LA. The patenting device MA is movable in the y-direction through the field region so as to expose a greater region of the patenting device MA in a single dynamic scanning exposure.

In one embodiment, the apparatus 800 shown in Figure 8 is provided within the lithographic apparatus LA by providing the pair of coils 840, 842 as rectangular coils on each of the y masking blades.

One potential disadvantage of this embodiment of an apparatus 800 is the placement of the magnetic field since all ions which are generated in a volume between the coils 840, 842 (which may be on the y masking blades) and the pellicle membrane 824 are not affected and will still travel to pellicle membrane 824.

The efficiency of the apparatus 800 shown in Figure 8 can be estimated by taking the ratio of diffusion coefficients in the direction of the magnetic field (parallel to the pellicle membrane 824), and perpendicular to the magnetic field (incident on the pellicle membrane 824). The ratio of perpendicular and parallel diffusion in a magnetic field is given by:

$$\frac{D_\perp}{D_\parallel} = \frac{1}{1 + \omega_c^2 t_c^2}$$

where $\omega_c$ is the larmor frequency and $t_c$ is the time between collisions. For the plasma conditions in the lithographic apparatus (as described above), it is found that for electrons the ratio of perpendicular and parallel diffusion in a magnetic

field $\frac{D_\perp}{D_\parallel} = 4 * 10^{-10}$ . That is, effectively all electrons diffuse along the field.

In each of the apparatus 600, 700, 800 shown in Figures 6, 7A and 8 respectively, there is provided a magnetic field generator that is operable to generate a magnetic field in the vicinity of an object when supported by a support. In an alternative embodiment, the magnetic field may be generated by passing a current through the hydrogen plasma, as now discussed.

In particular, the magnetic field generator may comprise a power supply that is arranged to generate a current through a plasma formed from the hydrogen supplied by a hydrogen supply in the vicinity of an object. As the power supply passes a current through the plasma, the plasma will contract in dimensions perpendicular to the current density vector. This is known as Z-pinch confinement. This system is called a Z-pinch confinement and has been studied extensively for nuclear fusion.

The magnetic field generator may comprise two electrodes disposed in the plasma and the power supply may be operable to apply a voltage across the two electrodes. That is, there may be direct contact between the power supply and the plasma. Alternatively, the power supply may be inductively coupled to the plasma and may be arranged to induce a current in the plasma.

For embodiments wherein the power supply may be operable to apply a voltage across two electrodes, the two electrodes may be disposed in any suitable position within the lithographic apparatus. For example, the electrodes may be provided on the masking blades, on a nozzle that forms part of the hydrogen supply or specifically designed extensions from the pellicle and/or reticle.

For embodiments wherein the power supply may be operable to apply a voltage across two electrodes, it may be desirable to maintain the voltage on the electrodes below 50-100V at least, preferably below 10V in order to avoid discharge in un-ionized gas.

When a small electrical current is passed through a plasma (or gas), rotational magnetic field lines are created around the current density vector. This magnetic field is capable of confining a plasma by trapping charged particles into circular orbits around the magnetic field. Due to the inherently full confinement of the plasma along the length of the current, the plasma density increases, which may also cause instabilities and a breach of confinement to occur rapidly. Nevertheless, this will be less of an issue in lowly ionized hydrogen plasma within a lithographic apparatus than in a fusion device. Furthermore if a large fraction of ion loss can be directed towards the source and drain electrodes which generate the current, the pellicle membrane may still be protected.

In each of the apparatus 600, 700, 800 shown in Figures 6, 7A and 8 respectively, as discussed above, it may be desirable for the magnetic field generator to be operable to generate a magnetic field in the vicinity of an object when supported by a support having a magnetic field strength of 0.2 T or greater.

In each of the apparatus 600, 700, 800 shown in Figures 6, 7A and 8 respectively, as discussed above, the magnetic field can direct charged particles (and in particular the hydrogen ions) away from the surface of the pellicle membrane. Advantageously, this can reduce the plasma etching rate and so extend the lifetime of the pellicle. It is estimated that at least an order of magnitude improvement in the lifetime of the pellicle membrane may be achieved.

Some embodiments relate to methods for reducing a flux of charged particles on a reticle and pellicle assembly for a lithographic apparatus. Generally, such methods may comprise: supporting an object; generating a hydrogen plasma in the vicinity of a surface of an object; and generating a magnetic field in the vicinity of the surface of the object, the magnetic field arranged to reduce a flux of charged particles from the plasma that is incident on the surface of the object.

Such methods are advantageous as now discussed. The method may have application within an EUV lithographic apparatus. The object may be a reticle and pellicle assembly. The hydrogen plasma can have a cleaning effect on the surface of the object (for example a reticle and pellicle assembly). However, objects formed from silicon and carbon compounds (such as pellicles for use in an EUV lithographic apparatus) suffer from Hydrogen Induced Outgassing (HIO). Through a few reaction steps, hydrogen plasma can remove the (native) oxide shell of such objects, and then the silicon or carbon core. For silicon-based pellicles, this etching of the silicon core by the hydrogen plasma forms silane $SiH_4$ whereas for carbon-based pellicles this etching of the carbon core by the hydrogen plasma forms methane compounds. Advantageously, by generating a magnetic field in the vicinity of the surface of the object that is arranged to reduce a flux of charged particles from the plasma that is incident on the surface of the object, the plasma etching rate is reduced and so the lifetime of the object is extended. It will be appreciated that the magnetic field acts on the charged particles in the plasma via the Lorentz force and, in so doing, can direct these charged particles (and in particular the hydrogen ions) away from the surface of the pellicle.

References to a mask or reticle in this document may be interpreted as references to a patterning device (a mask or reticle is an example of a patterning device) and the terms may be used interchangeably. In particular, the term mask assembly is synonymous with reticle assembly and patterning device assembly.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm such as 6.7 nm or 6.8 nm.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

**Claims**

1. An apparatus (200, 300) comprising:

   a support (220) for supporting a reticle and pellicle assembly (400, 500);
   a hydrogen supply (250) operable to supply hydrogen (252) in the vicinity of a pellicle of the reticle and pellicle assembly when supported by the support; and
   an electron source (210, 310) operable to direct electrons (212) so as to be incident on a pellicle of a reticle and pellicle assembly when supported by the support;
   wherein a part (222) of the support which, in use, contacts the reticle and pellicle assembly comprises an electron sink.

2. The apparatus (200, 300) of claim 1, wherein the part of the support which, in use, contacts the reticle and pellicle assembly is grounded.

3. The apparatus (200, 300) of claim 1 or 2, wherein the part of the support which, in use, contacts the reticle and pellicle assembly contacts part of the pellicle and/or part of the reticle.

4. The apparatus (200, 300) of any preceding claim wherein the support is configured such that when the reticle and pellicle assembly is supported thereby, it contacts a portion of a front side of the pellicle.

5. The apparatus (200, 300) of any preceding claim wherein the hydrogen supply is operable to supply hydrogen at a pressure in the range 50 to 100 Pa, preferably between the reticle and the pellicle of the reticle and pellicle assembly when supported by the support.

6. The apparatus (200, 300) of any preceding claim further comprising a thermal conditioning unit operable to control a temperature of the reticle and pellicle assembly when supported by the support wherein optionally the thermal conditioning unit comprises:

   - a heater operable to increase a temperature of the reticle and pellicle assembly when supported by the support, and/or
   - a cooling system operable to reduce a temperature of the reticle and pellicle assembly when supported by the support.

7. The apparatus (200, 300) of any preceding claim wherein when the reticle and pellicle assembly is supported by the support, the support provides an electrical connection between a reticle front surface and the pellicle.

8. The apparatus (200, 300) of any preceding claim wherein the electron source is arranged to direct electrons so as to be incident on a pellicle of the reticle and pellicle assembly when supported by the support such that a portion of said electrons which propagates through the pellicle has an energy of less than 500 eV.

9. The apparatus (200, 300) of any preceding claim further comprising an electromagnetic radiation source (370) operable to direct electromagnetic radiation at a pellicle of the reticle and pellicle assembly when supported by the support.

10. The apparatus (200, 300) of any preceding claim wherein the electron source is arranged to direct electrons so as to be incident on a pellicle of the reticle and pellicle assembly when supported by the support such that a portion of said electrons which propagates through the pellicle achieves a secondary electron yield of greater than 1.

11. The apparatus (200, 300) of any preceding claim further comprising an enclosure, wherein the support is disposed in the enclosure and wherein the hydrogen supply is operable to supply hydrogen to the enclosure.

12. The apparatus (200, 300) of any preceding claim wherein the hydrogen supply is operable to provide a flow of hydrogen (361) between a pellicle and a reticle of the reticle and pellicle assembly when supported by the support.

13. The apparatus (200, 300) of any preceding claim wherein:

- the electron source comprises an electron gun;
and/or
- the apparatus further comprises a scanning mechanism operable to move at least one of the electron source and the support such that electrons emitted by the electron source can be directed at a range of different parts of a pellicle of the reticle and pellicle assembly when supported by the support.

14. A lithographic apparatus (LA) comprising the apparatus (200, 300) of any preceding claim.

15. The apparatus (200, 300) according to any of the claims 1-13, further comprising the reticle and pellicle assembly (500), wherein the reticle and pellicle assembly further comprises a pellicle frame (503) arranged to support the pellicle (401, 402), the pellicle frame being arranged to engage with the reticle such that the pellicle is disposed adjacent the reticle;

wherein the pellicle comprises a central pellicle membrane (401) surrounded by a pellicle border (402); and wherein the pellicle frame comprises wall portions (505) arranged to provide a generally rectangular body surrounding a generally rectangular aperture (506) and wherein the wall portions are provided with at least one channel (504) from an exterior surface (507) of the wall portion to an interior surface (509) of the wall portion adjacent the generally rectangular aperture, the at least one channel being non-linear wherein the at least one channel optionally defines a convoluted or labyrinth flow path from the exterior surface of the wall portion to the interior surface of the wall portion adjacent the generally rectangular aperture.

**Patentansprüche**

1. Eine Vorrichtung (200, 300), die Folgendes beinhaltet:

einen Träger (220) zum Tragen einer Retikel- und Pellikelanordnung (400, 500);
eine Wasserstoffversorgung (250), die betriebsbereit ist, um Wasserstoff (252) in der Nähe eines Pellikels der Retikel- und Pellikelanordnung zu liefern, wenn diese von dem Träger getragen wird; und
eine Elektronenquelle (210, 310), die betriebsbereit ist, um Elektronen (212) so zu lenken, dass sie auf ein Pellikel einer Retikel- und Pellikelanordnung einfallen, wenn diese von dem Träger getragen wird;
wobei ein Teil (222) des Trägers, der im Gebrauch die Retikel- und Pellikelanordnung berührt, eine Elektronensenke beinhaltet.

2. Vorrichtung (200, 300) gemäß Anspruch 1, wobei der Teil des Trägers, der im Gebrauch die Retikel- und Pellikelanordnung berührt, geerdet ist.

3. Vorrichtung (200, 300) gemäß Anspruch 1 oder 2, wobei der Teil des Trägers, der im Gebrauch die Retikel- und Pellikelanordnung berührt, einen Teil des Pellikels und/oder einen Teil des Retikels berührt.

4. Vorrichtung (200, 300) gemäß einem der vorhergehenden Ansprüche, wobei der Träger so konfiguriert ist, dass er einen Abschnitt einer Vorderseite des Pellikels berührt, wenn die Retikel- und Pellikelanordnung von ihm getragen wird.

5. Vorrichtung (200, 300) gemäß einem der vorhergehenden Ansprüche, wobei die Wasserstoffversorgung betriebsbereit ist, um Wasserstoff mit einem Druck in dem Bereich von 50 bis 100 Pa zu liefern, vorzugsweise zwischen dem Retikel und dem Pellikel der Retikel- und Pellikelanordnung, wenn diese von dem Träger getragen wird.

6. Vorrichtung (200, 300) gemäß einem der vorhergehenden Ansprüche, die ferner eine Thermokonditionierungseinheit beinhaltet, die betriebsbereit ist, um eine Temperatur der Retikel- und Pellikelanordnung zu steuern, wenn diese von dem Träger getragen wird, wobei die Thermokonditionierungseinheit optional Folgendes beinhaltet:

   - ein Heizgerät, das betriebsbereit ist, um eine Temperatur der Retikel- und Pellikelanordnung zu erhöhen, wenn diese von dem Träger getragen wird,
   und/oder
   - ein Kühlsystem, das betriebsbereit ist, um eine Temperatur der Retikel- und Pellikelanordnung zu senken, wenn diese von dem Träger getragen wird.

7. Vorrichtung (200, 300) gemäß einem der vorhergehenden Ansprüche, wobei der Träger eine elektrische Verbindung zwischen einer vorderen Retikeloberfläche und dem Pellikel bereitstellt, wenn die Retikel- und Pellikelanordnung von dem Träger getragen wird.

8. Vorrichtung (200, 300) gemäß einem der vorhergehenden Ansprüche, wobei die Elektronenquelle eingerichtet ist, um Elektronen so zu lenken, dass sie auf ein Pellikel der Retikel- und Pellikelanordnung einfallen, wenn diese von dem Träger getragen wird, sodass ein Anteil der Elektronen, der sich durch das Pellikel ausbreitet, eine Energie von weniger als 500 eV aufweist.

9. Vorrichtung (200, 300) gemäß einem der vorhergehenden Ansprüche, die ferner eine Quelle (370) elektromagnetischer Strahlung beinhaltet, die betriebsbereit ist, um elektromagnetische Strahlung auf ein Pellikel der Retikel- und Pellikelanordnung zu lenken, wenn diese von dem Träger getragen wird.

10. Vorrichtung (200, 300) gemäß einem der vorhergehenden Ansprüche, wobei die Elektronenquelle eingerichtet ist, um Elektronen so zu lenken, dass sie auf ein Pellikel der Retikel- und Pellikelanordnung einfallen, wenn diese von dem Träger getragen wird, sodass ein Anteil der Elektronen, der sich durch das Pellikel ausbreitet, eine Sekundärelektronenausbeute von mehr als 1 erreicht.

11. Vorrichtung (200, 300) gemäß einem der vorhergehenden Ansprüche, die ferner eine Hülle beinhaltet, wobei der Träger in der Hülle angeordnet ist und wobei die Wasserstoffversorgung betriebsbereit ist, um Wasserstoff zu der Hülle zu liefern.

12. Vorrichtung (200, 300) gemäß einem der vorhergehenden Ansprüche, wobei die Wasserstoffversorgung betriebsbereit ist, um einen Fluss von Wasserstoff (361) zwischen einem Pellikel und einem Retikel der Retikel- und Pellikelanordnung bereitzustellen, wenn diese von dem Träger getragen wird.

13. Vorrichtung (200, 300) gemäß einem der vorhergehenden Ansprüche, wobei:

   - die Elektronenquelle eine Elektronenkanone beinhaltet;
   und/oder
   - die Vorrichtung ferner einen Scanmechanismus beinhaltet, der betriebsbereit ist, um mindestens eines von der Elektronenquelle und dem Träger so zu bewegen, dass von der Elektronenquelle emittierte Elektronen auf einen Bereich von unterschiedlichen Teilen eines Pellikels der Retikel- und Pellikelanordnung gelenkt werden können, wenn diese von dem Träger getragen wird.

14. Eine lithographische Vorrichtung (LA), die die Vorrichtung (200, 300) gemäß einem der vorhergehenden Ansprüche beinhaltet.

15. Vorrichtung (200, 300) gemäß einem der Ansprüche 1-13, die ferner die Retikel- und Pellikelanordnung (500) beinhaltet, wobei die Retikel- und Pellikelanordnung ferner einen Pellikelrahmen (503) beinhaltet, der eingerichtet ist, um das Pellikel (401, 402) zu tragen, wobei der Pellikelrahmen eingerichtet ist, um so mit dem Retikel ineinander zu greifen, dass das Pellikel angrenzend an das Retikel angeordnet wird;

   wobei das Pellikel eine zentrale Pellikelmembran (401) beinhaltet, die von einem Pellikelrand (402) umgeben ist; und
   wobei der Pellikelrahmen Wandabschnitte (505) beinhaltet, die eingerichtet sind, um einen im Allgemeinen rechteckigen Körper bereitzustellen, der eine im Allgemeinen rechteckige Apertur (506) umgibt, und wobei die Wandabschnitte mit mindestens einem Kanal (504) von einer äußeren Oberfläche (507) des Wandabschnitts zu einer an die im Allgemeinen rechteckige Apertur angrenzenden inneren Oberfläche (509) des Wandabschnitts versehen sind, wobei der mindestens eine Kanal nichtlinear ist, wobei der mindestens eine Kanal optional eine gewundene oder labyrinthartige Fließbahn von der äußeren Oberfläche des Wandabschnitts zu der an die im Allgemeinen rechteckige Apertur angrenzenden inneren Oberfläche des Wandabschnitts definiert.

**Revendications**

1. Un appareil (200, 300) comprenant :

   un support (220) pour supporter un ensemble réticule et pellicule (400, 500) ;
   un dispositif d'apport d'hydrogène (250) exploitable pour apporter de l'hydrogène (252) au voisinage d'une pellicule de l'ensemble réticule et pellicule lorsqu'il est supporté par le support ; et
   une source d'électrons (210, 310) exploitable pour diriger des électrons (212) de manière à ce qu'ils soient incidents sur une pellicule d'un ensemble réticule et pellicule lorsqu'il est supporté par le support ;
   où une partie (222) du support qui, en utilisation, est au contact de l'ensemble réticule et pellicule comprend un puits d'électrons.

2. L'appareil (200, 300) de la revendication 1, où la partie du support qui, en utilisation, est au contact de l'ensemble réticule et pellicule est mise à la terre.

3. L'appareil (200, 300) de la revendication 1 ou de la revendication 2, où la partie du support qui, en utilisation, est au contact de l'ensemble réticule et pellicule est au contact d'une partie de la pellicule et/ou d'une partie du réticule.

4. L'appareil (200, 300) de n'importe quelle revendication précédente où le support est configuré de telle sorte que lorsque l'ensemble réticule et pellicule est supporté par celui-ci, il est au contact d'une portion d'un côté avant de la pellicule.

5. L'appareil (200, 300) de n'importe quelle revendication précédente où le dispositif d'apport d'hydrogène est exploitable pour apporter de l'hydrogène à une pression comprise dans l'éventail de 50 à 100 Pa, préférablement entre le réticule et la pellicule de l'ensemble réticule et pellicule lorsqu'il est supporté par le support.

6. L'appareil (200, 300) de n'importe quelle revendication précédente comprenant en sus une unité de conditionnement thermique exploitable pour contrôler une température de l'ensemble réticule et pellicule lorsqu'il est supporté par le support où facultativement l'unité de conditionnement thermique comprend :

   - un élément chauffant exploitable pour faire monter une température de l'ensemble réticule et pellicule lorsqu'il est supporté par le support,
   et/ou
   - un système de refroidissement exploitable pour faire baisser une température de l'ensemble réticule et pellicule lorsqu'il est supporté par le support.

7. L'appareil (200, 300) de n'importe quelle revendication précédente où lorsque l'ensemble réticule et pellicule est supporté par le support, le support fournit une connexion électrique entre une surface avant de réticule et la pellicule.

8. L'appareil (200, 300) de n'importe quelle revendication précédente où la source d'électrons est agencée pour diriger des électrons de manière à ce qu'ils soient incidents sur une pellicule de l'ensemble réticule et pellicule lorsqu'il est supporté par le support de telle sorte qu'une portion desdits électrons qui se propage à travers la pellicule a une énergie de moins de 500 eV.

9. L'appareil (200, 300) de n'importe quelle revendication précédente comprenant en sus une source de rayonnement électromagnétique (370) exploitable pour diriger un rayonnement électromagnétique sur une pellicule de l'ensemble réticule et pellicule lorsqu'il est supporté par le support.

10. L'appareil (200, 300) de n'importe quelle revendication précédente où la source d'électrons est agencée pour diriger des électrons de manière à ce qu'ils soient incidents sur une pellicule de l'ensemble réticule et pellicule lorsqu'il est supporté par le support de telle sorte qu'une portion desdits électrons qui se propage à travers la pellicule atteint un rendement électronique secondaire de plus de 1.

**11.** L'appareil (200, 300) de n'importe quelle revendication précédente comprenant en sus une enceinte, où le support est disposé dans l'enceinte et où le dispositif d'apport d'hydrogène est exploitable pour apporter de l'hydrogène à l'enceinte.

**12.** L'appareil (200, 300) de n'importe quelle revendication précédente où le dispositif d'apport d'hydrogène est exploitable pour fournir un flux d'hydrogène (361) entre une pellicule et un réticule de l'ensemble réticule et pellicule lorsqu'il est supporté par le support.

**13.** L'appareil (200, 300) de n'importe quelle revendication précédente où :

- la source d'électrons comprend un canon à électrons ;
et/ou
- l'appareil comprend en sus un mécanisme de balayage exploitable pour déplacer au moins un élément parmi la source d'électrons et le support de telle sorte que des électrons émis par la source d'électrons peuvent être dirigés sur un éventail de différentes parties d'une pellicule de l'ensemble réticule et pellicule lorsqu'il est supporté par le support.

**14.** Un appareil lithographique (LA) comprenant l'appareil (200, 300) de n'importe quelle revendication précédente.

**15.** L'appareil (200, 300) selon n'importe lesquelles des revendications 1 à 13, comprenant en sus l'ensemble réticule et pellicule (500), où l'ensemble réticule et pellicule comprend en sus un cadre de pellicule (503) agencé pour supporter la pellicule (401, 402), le cadre de pellicule étant agencé pour se mettre en engagement avec le réticule de telle sorte que la pellicule est disposée adjacente au réticule ;

où la pellicule comprend une membrane de pellicule (401) centrale entourée d'une bordure de pellicule (402) ; et où le cadre de pellicule comprend des portions de paroi (505) agencées pour fournir un corps généralement rectangulaire entourant une ouverture généralement rectangulaire (506) et où les portions de paroi sont pourvues d'au moins un canal (504) allant d'une surface extérieure (507) de la portion de paroi à une surface intérieure (509) de la portion de paroi adjacente à l'ouverture généralement rectangulaire, l'au moins un canal étant non linéaire où l'au moins un canal définit facultativement une voie d'écoulement convolutée ou en labyrinthe allant de la surface extérieure de la portion de paroi à la surface intérieure de la portion de paroi adjacente à l'ouverture généralement rectangulaire.

Fig. 1

Fig. 2

Fig. 3

400

402     401     403

408     410

**Fig. 4A**

400

**A-A**

403

L_frame

WF

W_frame

UF

**Fig. 4B**

**Fig. 5A**

**Fig. 5B**

**Fig. 6**

**Fig. 7A**

**Fig. 7B**

Fig. 8

**EP 4 200 670 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 20192426
- EP 20199008
- WO 2020064217 A
- US 20150160569 A1
- US 20150131071 A1
- US 20160225582 A1
- WO 2016079051 A
- US 20160291460 A1